(19) Europäisches Patentamt / European Patent Office / Office européen des brevets

(11) **EP 1 947 796 A2**

(12) **EUROPEAN PATENT APPLICATION**

(43) Date of publication:
**23.07.2008 Bulletin 2008/30**

(51) Int Cl.:
***H04L 1/00*** (2006.01)

(21) Application number: **07118041.8**

(22) Date of filing: **08.10.2007**

| | |
|---|---|
| (84) Designated Contracting States: **AT BE BG CH CY CZ DE DK EE ES FI FR GB GR HU IE IS IT LI LT LU LV MC MT NL PL PT RO SE SI SK TR** Designated Extension States: **AL BA HR MK RS** | (72) Inventor: **Ikeda, Norihiro** **c/o FUJITSU LIMITED** **Kawasaki-shi, Kanagawa 211-8588 (JP)** |
| (30) Priority: **26.12.2006 JP 2006349378** | (74) Representative: **Fenlon, Christine Lesley et al** **Haseltine Lake** **5th Floor, Lincoln House** **300 High Holborn** **London WC1V 7JH (GB)** |
| (71) Applicant: **FUJITSU LIMITED** **Kawasaki-shi, Kanagawa 211-8588 (JP)** | |

(54) **Method and apparatus for dividing information bit string**

(57) A method of dividing an information bit string by a generator polynomial includes dividing the information bit string into a plurality of sub-bit strings A1 through AN, multiplying a remainder value by each bit of a sub-bit string Ai ($1 \leqq i \leqq N$) successively with a most significant bit first so as to produce a multiplication result corresponding to the sub-bit string Ai, the remainder value being obtained by dividing a polynomial representation by the generator polynomial wherein the polynomial representation represents a bit string in which a bit position in the information bit string corresponding to a least significant bit of the sub-bit string Ai is set to "1" and remaining bit positions are set to "0", and dividing, by the generator polynomial, a polynomial representing a bit string obtained by performing modulo-2 addition that adds up multiplication results corresponding to the sub-bit strings A1 through AN.

FIG.1

**Description**

**BACKGROUND OF THE INVENTION**

1. Field of the Invention

The present invention generally relates to a method and apparatus for dividing an information bit string. The present invention particularly relates to a method and apparatus for dividing an information bit string that performs error detection coding or decoding with respect to an information bit string.

2. Description of the Related Art

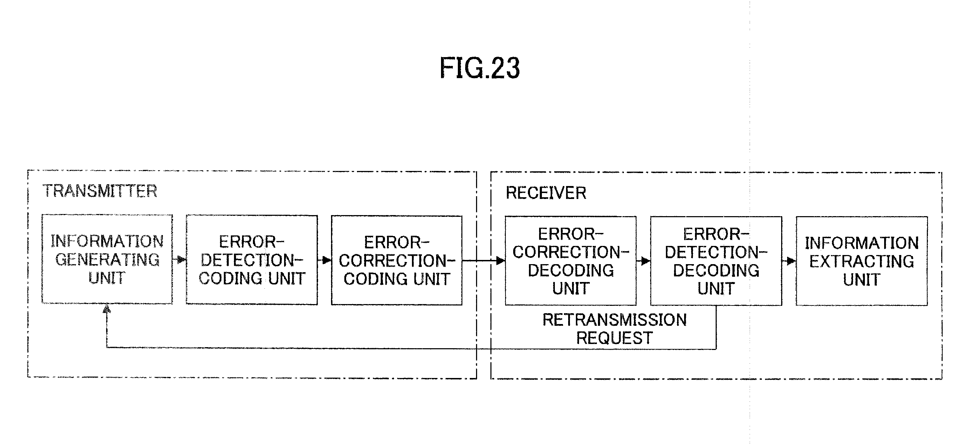

Error diction code is used in a data transmission system that is required to transmit data without error, and is also used in an external storage device or the like that is required to read data without error. Error detection code is used for the purpose of detecting transmission error. Fig. 23 is a drawing showing an example of a system to which error detection code is applied. The transmitter performs error correction coding after performing error detection coding on a transmission signal, and transmits the transmission signal to a receiver via a transmission channel. The receiver performs error correction decoding on the received signal, followed by performing error detection coding. If there is an error that cannot be corrected by the error correction decoding, the receiver sends a retransmission request signal to the transmitter, so that data is retransmitted. As a result, the receiver can acquire data that is error free.

The CRC (Cyclic Redundancy Check) code is one type of error detection code, and is more often used than other types cf error detection codes due to its capability of detecting burst errors. In the generation of a CRC code on the transmitter side, n-bit information bits are treated as a polynomial, which is divided by a generator polynomial. An m-bit remainder generated in this manner is added to the information bits to produce an (n+m)-bit string, thereby generating code data that is divisible by the generator polynomial. On the receiver side, the received data is divided by the generator polynomial. Error detection is performed by finding no error if the remainder is zero and otherwise finding error. Division calculation needs to be performed for the coding and decoding of a CRC code. A divider for this purpose may be implemented as hardware by use of a relatively simple circuit.

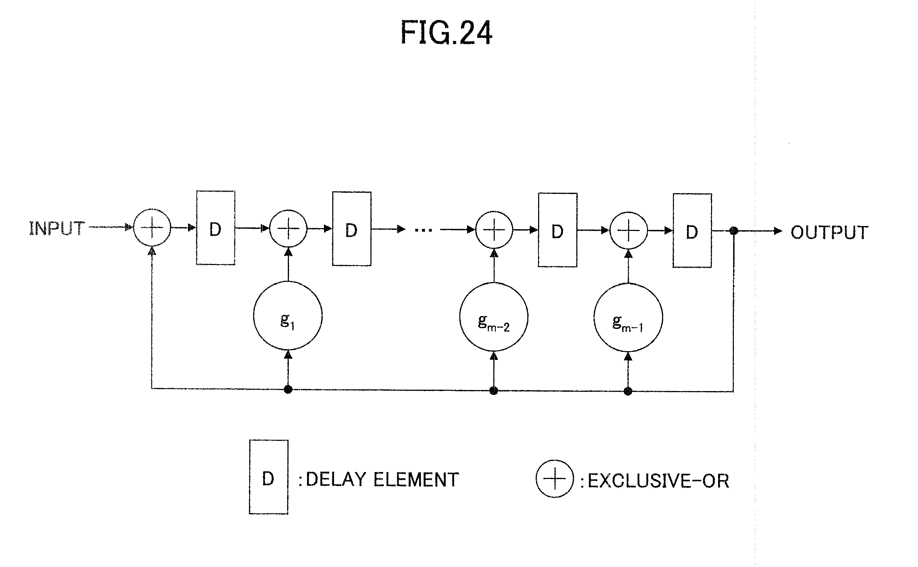

Fig. 24 is a block diagram showing an example of a divider circuit. This is an example of a typical structure in which an input signal bit string is divided by a generator polynomial $G(x) = x^m + g_{m-1}x^{m-1} + ... + g_1x + 1$. The divider circuit can be implemented by use of a simple circuit comprised of shift registers and exclusive OR gates (+). In Fig. 24, each coefficient $g_i$ assumes either a value of "0" or a value of "1". The corresponding line is connected if $g_i = 1$, and is disconnected if $g_i = 0$. With this configuration, the inputting of a dividend polynomial with its most significant bit first results in the quotient polynomial being output with its most significant bit first. When the inputting of all the bits of the dividend polynomial is completed, the delay elements D store the remainder polynomial.

In a divider used for the coding and decoding of a CRC code, there is a need to input all the bits of an input polynomial successively with its highest-order term first. For the purpose of performing division, thus, a number of steps corresponding to the number of input bits need to be performed, giving rise to the problem that there is a large delay in the processing time.

In this regard, there is a divider apparatus (Patent Document 1) that divides an input data string into a plurality of sub-blocks, and performs division calculations concurrently in these sub-blocks for the purpose of achieving faster division calculation. The method disclosed in Patent Document 1 obtains partial remainders by performing division calculations individually in the sub-blocks, and performs shifting on each remainder by use of a shift matrix matching the order of each sub-block, followed by combining (through modulo-2 summation) the shifted remainders to produce a final remainder.

[Patent Document 1] Patent Application No. 2003-587014 (WO2003/090362)
[Patent Document 2] Japanese Patent Application Publication No. 2004-15285

In the method disclosed in Patent Document 1, one shift matrix is necessary for one shift amount. When the degree of a generator polynomial is m, a shift matrix is a matrix with a size of m x m whose elements are either "0" or "1". If the length of input data is variable, thus, there is a need for the means to produce a shift matrix corresponding to a given data length. With an implementation using a ROM table, a memory size of $m^2$ bits per shift amount is necessary, resulting in the need for a large ROM capacity, which would negatively affect the circuit size. For example, a ROM size of 2.9 Mbits (=5114 x 24 x 24) is necessary if the length of input data is 5114 bits and the matrix size is 24 x 24 bits.

Accordingly, there is a need for a method and apparatus for dividing an information bit string that can perform the division of an information string at high speed. There is also a need for a method and apparatus for dividing an information bit string that can perform the division of an information string at high speed by use of a relatively small table size.

## SUMMARY OF THE INVENTION

It is a general object of the present invention to provide a method and apparatus for dividing an information bit string that substantially obviate one or more problems caused by the limitations and disadvantages of the related art.

Features and advantages of the present invention will be presented in the description which follows, and in part will become apparent from the description and the accompanying drawings, or may be learned by practice of the invention according to the teachings provided in the description. Objects as well as other features and advantages of the present invention will be realized and attained by a method and apparatus for dividing an information bit string particularly pointed out in the specification in such full, clear, concise, and exact terms as to enable a person having ordinary skill in the art to practice the invention.

To achieve these and other advantages in accordance with the purpose of the invention, the invention provides a method of dividing an information bit string by a generator polynomial in a calculation apparatus having a multiplication unit and an addition unit, which includes dividing the information bit string into a plurality of sub-bit strings A1 through AN, causing the multiplication unit to multiply a remainder value by each bit of a sub-bit string Ai ($1 \leqq i \leqq N$) successively with a most significant bit first so as to produce a multiplication result corresponding to the sub-bit string Ai, the remainder value being obtained by dividing a polynomial representation by the generator polynomial wherein the polynomial representation represents a bit string in which a bit position in the information bit string corresponding to a least significant bit of the sub-bit string Ai is set to "1" and remaining bit positions are set to "0", and dividing, by the generator polynomial, y a polynomial representing a bit string obtained by the addition unit performing modulo-2 addition that adds up multiplication results corresponding to the sub-bit strings A1 through AN.

According to another aspect of the present invention, an apparatus for dividing an information bit string by a generator polynomial includes a division unit configured to divide the information bit string into a plurality of sub-bit strings A1 through AN, a multiplication unit configured to multiply a remainder value by each bit of a sub-bit string Ai ($1 \leqq i \leqq N$) successively with a most significant bit first so as to produce a multiplication result corresponding to the sub-bit string Ai, the remainder value being obtained by dividing a polynomial representation by the generator polynomial wherein the polynomial representation represents a bit string in which a bit position in the information bit string corresponding to a least significant bit of the sub-bit string Ai is set to "1" and remaining bit positions are set to "0", and an addition unit configured to obtain a summed bit string by performing modulo-2 addition that adds up multiplication, results corresponding to the sub-bit strings A1 through AN; anda division unit configured to divide a polynomial representing the summed bit string by the generator polynomial.

According to another aspect of the present invention, an apparatus for dividing an information bit string includes a multiplication, unit configured to multiply a remainder value by each bit of a sub-bit string successively with a most significant bit first so as to obtain a multiplication result, the sub-bit string being one of a plurality of sub-bit strings into which the information bit string is divided, and the remainder value being obtained by dividing a bit "1" corresponding to an order of a least significant bit of the sub-bit string by a generator polynomial, an addition unit configured to perform modulo-2 addition that adds multiplication results obtained by the multiplication unit to an existing remainder value so as to obtain a sum, and a division unit configured to successively divide the sum obtained by the addition unit by the generator polynomial to produce a remainder, which is retained as the existing remainder value.

According to another aspect of the present invention, an error-detection-coding apparatus includes a division unit configured to add to an information bit string on a least-significant-bit side thereof as many zeros as necessary for CRC bits so as to produce an extended bit string and to divide the extended bit string into a plurality of sub-bit strings, a multiplication unit configured to multiply a remainder value by each bit of one of the sub-bit strings successively with a most significant bit first so as to obtain a multiplication result, the remainder value being obtained by dividing a bit "1" corresponding to an order of a least significant bit of the one of the sub-bit springs by a generator polynomial, an addition unit configured to perform modulo-2 addition that adds multiplication results obtained by the multiplication unit to an existing remainder value so as to obtain a sum, and a division unit configured to successively divide the sum obtained by the addition unit by the generator polynomial to produce a remainder, which is retained as the existing remainder value.

According to another aspect of the present invention, an error-detection-coding apparatus includes a division unit configured to divide an information bit string into a plurality of sub-bit strings, a multiplication unit configured to multiply a remainder value by each bit of one of the sub-bit strings successively with a most significant bit first so as to obtain a multiplication result, the remainder value being obtained by dividing by a generator polynomial a bit "1" corresponding to an order of a least significant bit of the one of the sub-bit strings shifted left by as many bits as a number of CRC bits, an addition unit configured to perform modulo-2 addition that adds multiplication results obtained by the multiplication unit to an existing remainder value so as to obtain a sum, and a division unit configured to successively divide the sum obtained by the addition unit by the generator polynomial to produce a remainder, which is retained as the existing remainder value.

According to another aspect of the present invention, an error-detection-decoding apparatus includes a division unit configured to divide a received bit string inclusive of a CRC code into a plurality of sub-bit strings, a multiplication unit configured to multiply a remainder value by each bit of one of the sub-bit strings successively with a most significant bit first so as to obtain a multiplication result, the remainder value being obtained by dividing a bit "1" corresponding to an order of a least significant bit of the one of the sub-bit strings by a generator polynomial, an addition unit configured to perform modulo-2 addition that adds multiplication results obtained by the multiplication unit to an existing remainder value so as to obtain a sum, a division unit configured to successively divide the sum obtained by the addition unit by the generator polynomial to produce a remainder, which is retained as the existing remainder value, and an error-detection unit configured to check whether all bits of a final remainder value obtained by the division unit are zero.

According to another aspect of the present invention, an error-detection-decoding apparatus includes a division unit configured to divide a received bit string having CRC bits thereof replaced with zeros into a plurality of sub-bit strings, a multiplication unit configured to multiply a remainder value by each bit of one of the sub-bit strings successively with a most significant bit first so as to obtain a multiplication result, the remainder value being obtained by dividing a bit "1" corresponding to an order of a least significant bit of the one of the sub-bit strings by a generator polynomial, an addition unit configured to perform modulo-2 addition that adds multiplication results obtained by the multiplication unit to an existing remainder value so as to obtain a sum, a division unit configured to successively divide the sum obtained by the addition unit by the generator polynomial to produce a remainder, which is retained as the existing remainder value, and an error-detection unit configured to check whether a final remainder value obtained by the division unit matches the CRC bits extracted from the received bit string.

According to another aspect of the present invention, an error-detection-decoding apparatus includes a division unit configured to divide an information bit string included in a received bit string inclusive of a CRC code into a plurality of sub-bit strings, a multiplication unit configured to multiply a remainder value by each bit of one of the sub-bit strings successively with a most significant bit first so as to obtain a multiplication result, the remainder value being obtained by dividing by a generator polynomial a bit "1" corresponding to an order of a least significant bit of the one of the sub-bit strings shifted left by as many bits as a number of CRC bits, an addition unit configured to perform modulo-2 addition that adds multiplication results obtained by the multiplication unit to an existing remainder value so as to obtain a sum, a division unit configured to successively divide the sum obtained by the addition unit by the generator polynomial to produce a remainder, which is retained as the existing remainder value, and an error-detection unit configured to check whether a final remainder value obtained by the division unit matches the CRC code extracted from the received bit string.

According to another aspect of the present invention, an apparatus for dividing an information bit string includes a multiplication unit configured to multiply a remainder value by each bit of a sub-bit string successively with a most significant bit first so as to obtain a multiplication result, the sub-bit string being one of a plurality of sub-bit strings into which an information bit string of each code block is divided, and the remainder value being obtained by dividing a bit "1" corresponding to an order of a least significant bit of the sub-bit string by a generator polynomial, an addition unit configured to perform modulo-2 addition that adds multiplication results obtained by the multiplication unit to an existing remainder value so as to obtain a sum, a division unit configured to successively divide the sum obtained by the addition unit by the generator polynomial to produce a remainder value, which is retained as the existing remainder value, and an attaching unit configured to attach a remainder value obtained by the division unit for a current code block to a highest-order sub-bit string of a next code block.

According to at least one embodiment of the present invention, a method and apparatus for dividing an information bit string is provided that can perform the division of an information string at high speed. Further, the division of an information bit string is performed with a relatively small table size. It suffices for the table for storing remainder values for division operations to have m-bit data stored for each order of an input bit string. The size of the table is thus reduced to 1/m, compared with the configuration used in Patent Document 1.

## BRIEF DESCRIPTION OF THE DRAWINGS

Other objects and further features of the present invention will be apparent from the following detailed description when read in conjunction with the accompanying drawings, in which :

Fig. 1 is a drawing showing the principle of a division apparatus according to the present invention;
Fig. 2 is a drawing showing the principle of a division unit according to the present invention;
Fig. 3 is a block diagram showing the division apparatus according to the first embodiment;
Fig. 4 is an illustrative drawing for explaining the operation of the division apparatus according to the first embodiment;
Fig. 5 is a block diagram showing the division apparatus according to a second embodiment;
Fig. 6 is a block diagram showing the division apparatus according to a third embodiment;
Fig. 7 is an illustrative drawing for explaining the operation of the remainder table according to the third embodiment;
Fig. 8 is a block diagram showing an error-detection-coding apparatus according to a forth embodiment;

Figs. 9A and 9B are illustrative drawings for explaining the operation of an error-detection-coding apparatus according to the forth embodiment;

Fig. 10 is an illustrative drawing for explaining the operation of an error-detection-coding apparatus according to the forth embodiment;

Fig. 11 is a block diagram showing an error-detection-coding apparatus according to a fifth embodiment;

Figs. 12A and 12B are illustrative drawings for explaining the operation of the error-detection-coding apparatus according to the fifth embodiment;

Fig. 13 is an illustrative drawing for explaining the operation of the error-detection-coding apparatus according to the fifth embodiment;

Fig. 14 is a block diagram showing an error-detection-decoding apparatus according to a sixth embodiment;

Figs. 15A and 15B are illustrative drawings for explaining the operation of the error-detection-decoding apparatus according to the sixth embodiment;

Fig. 16 is a block diagram showing an error-cetection-decoding apparatus according to a seventh embodiment;

Figs. 17A and 17B are illustrative drawings for explaining the operation of the error-detection-decoding apparatus according to the seventh embodiment;

Fig. 18 is a block diagram showing an error-detection-decoding apparatus according to an eighth embodiment;

Figs. 19A and 19B are illustrative drawings for explaining the operation of the error-detection-decoding apparatus according to the eighth embodiment;

Fig. 20 is a block diagram showing an error-detection-decoding apparatus according to a ninth embodiment;

Fig. 21 is an illustrative drawing for explaining the operation of the error-detection-decoding apparatus according to the ninth embodiment;

Fig. 22 is an illustrative drawing for explaining the operation of the error-detection-decoding apparatus according to the ninth embodiment;

Fig. 23 is a drawing showing an example of a system in which error-detection codes are used;

Fig. 24 is a block diagram showing an example of a division circuit; and

Fig. 25 is a table showing logic operations performed by a division unit.

## DESCRIPTION OF THE PREFERRED EMBODIMENT

In the following, the principle of a division method acccording to the present invention will be described.

In the following, all operations are modulo-2 operations. An operator representing modulo-2 addition is "+". Input data is represented by polynomial A(x), which is divided by a generator polynomial G (x) of the m-th order to produce a remainder. A(x) is divided into M sub-blocks $A_k(x)$ $(0 \leq k \leq M-1)$. The number of bits in each sub-block is arbitrary, and the number of bits of $A_k(x)$ is represented as $n_k$. The index k is assigned such that the smaller the value of k, the smaller the order of the corresponding sub-block is. Input data A(x) is then represented as:

$$A(x) = \sum_{k=0}^{M-1} A_k(x) x^{N_k} \qquad (1)$$

Here, the order of k-th sub-block $A_k(x)$ is as follows.

$$N_k = \begin{cases} 0 & k = 0 \\ \displaystyle\sum_{i=0}^{k-1} n_i & k \geq 1 \end{cases} \qquad (2)$$

The polynomial expression of data of each sub-block is as follows.

$$A_k(x) = \sum_{i=0}^{n_k-1} a_{i,k} x^i \qquad (3)$$

$a_{i,k}$ is the i-th bit of the k-th sub-block, and assumes either "0" or "1".

For the sake of simplicity of representation, the longest bit length among the sub-block bit lengths is denoted as n, and $A_k(x)$ is redefined as follows where $a_{i,k}=0$ for $i \geqq n_k$.

$$A_k(x) = \sum_{i=0}^{n-1} a_{i,k} x^i \qquad (4)$$

The input polynomial is rewritten by incorporating expression (4) into expression (1) as follows.

$$A(x) = \sum_{k=0}^{M-1} A_k(x) x^{N_k}$$

$$= \sum_{k=0}^{M-1} \sum_{i=0}^{n-1} a_{i,k} x^i x^{N_k}$$

$$= \sum_{i=0}^{n-1} \left( \sum_{k=0}^{M-1} a_{i,k} x^{N_k} \right) x^i \qquad (5)$$

The quotient polynomial obtained by dividing $x^{NK}$ by $G(x)$ is represented as $Q_{Nk}(x)$, and the remainder polynomial is represented as $R_{Nk}(x)$. $x^{NK}$ is then represented as :

$$x^{N_k} = Q_{N_k}(x) \cdot G(x) + R_{N_k}(x) \qquad (6)$$

The following expression is obtained by incorporating expression (6) into expression (5).

$$A(x) = \sum_{i=0}^{n-1} \left( \sum_{k=0}^{M-1} a_{i,k} x^{N_k} \right) x^i$$

$$= \sum_{i=0}^{n-1} \left( \sum_{k=0}^{M-1} a_{i,k} \left( Q_{N_k}(x) \cdot G(x) + R_{N_k}(x) \right) \right) x^i$$

$$= G(x) \cdot \sum_{i=0}^{n-1} \left( \sum_{k=0}^{M-1} a_{i,k} \cdot Q_{N_k}(x) \right) x^i + \sum_{i=0}^{n-1} \left( \sum_{k=0}^{M-1} a_{i,k} R_{N_k}(x) \right) x^i \qquad (7)$$

The first term of expression (7) is divisible by $G(x)$, so that the remainder of $A(x)/G(x)$ is equal to the remainder obtained by dividing the second term by $G(x)$. Namely, the remainder being sought is the remainder of the following.

$$\sum_{i=0}^{n-1} \left( \sum_{k=0}^{M-1} a_{i,k} R_{N_k}(x) \right) x^i \div G(x) \qquad (8)$$

Here, the following representation is used.

$$B_i(x) = \sum_{k=0}^{M-1} a_{i,k} R_{N_k}(x) \qquad (9)$$

Bi (x) is the summation of products for all the sub-blocks where each of the products is obtained by multiplying an input data bit of a given sub-block by remainder polynomial $R_{Nk}(x)$ corresponding to the order of the given sub-block. Accordingly, Bi(x) is a polynomial whose order is smaller than or equal to m-1. Further, the remainder being sought is the remainder of the following.

$$\sum_{i=0}^{n-1} B_i(x)x^i \div G(x) \qquad (10)$$

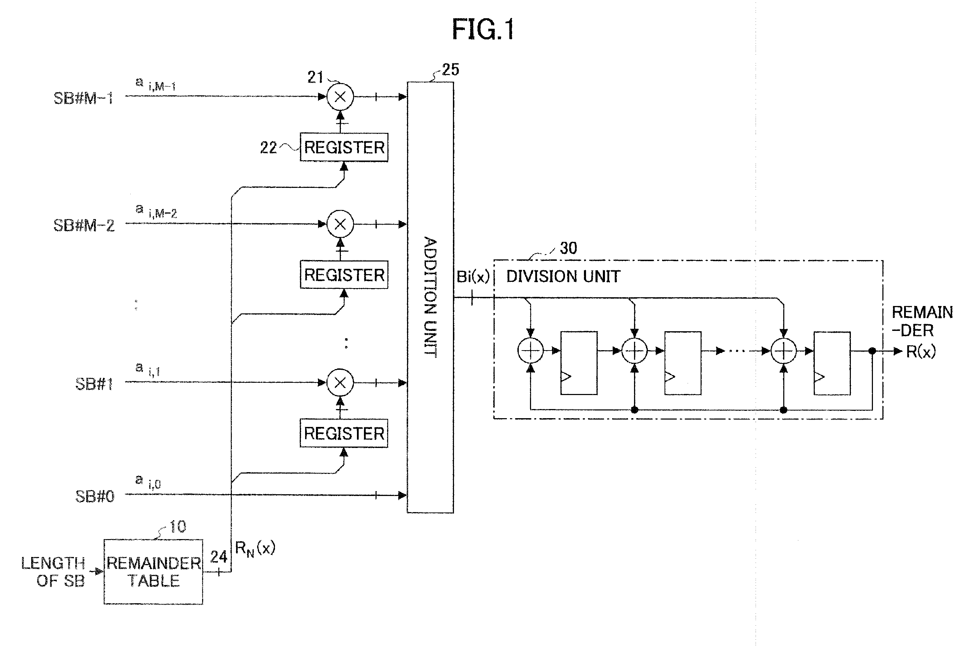

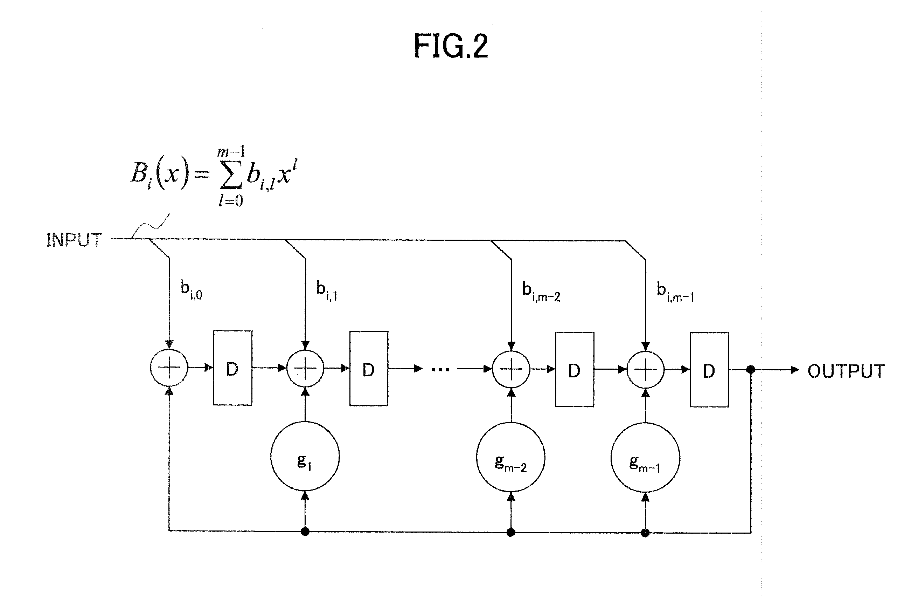

This is obtainable by the circuits shown in Fig. 1 and Fig.2 which use a divider circuit employing shift registers. As is understood from the above description, the calculation as described above can be performed when remainder polynomials $R_{Nk}(x)$ corresponding to the orders of the divided sub-blocks are known in advance.

In the following, embodiments of the present invention will be described with reference to the accompanying drawings. Throughout the drawings, the same reference numbers are used to refer to the same or corresponding elements.

[First Embodiment]

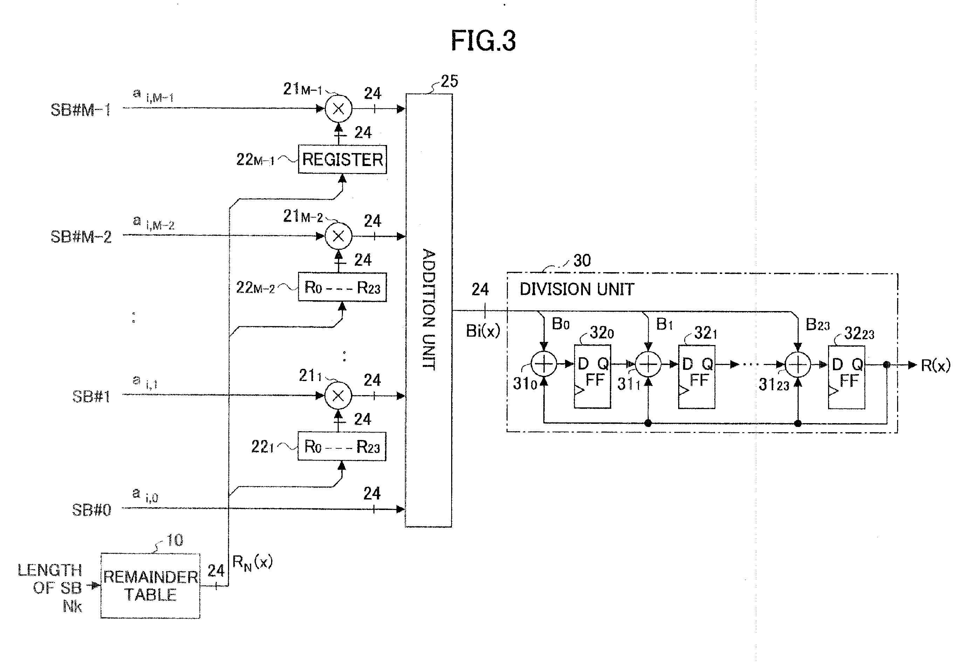

Fig. 3 is a block diagram showing a division apparatus according to a first embodiment. Fig. 3 shows an example of the configuration for performing division as defined in expression (8). Fig. 3 shows a remainder table 10 for providing corresponding remainder values according to information about the lengths of sub-blocks, multipliers 21 ($21_1$ through $21_{M-1}$) each for multiplying each bit of an input sub-bit string by a corresponding remainder value, registers 22 ($22_1$ through $22_{M-1}$) for storing the remainder values corresponding to respective input sub-bit strings, an addition unit 25 for performing modulo-2 addition, a division unit 30 for dividing the output of the addition unit 25 by the generator polynomial G(x), modulo-2 adders 31 $31_0$ through $31_{23}$) for adding the output of the addition unit 25 to the existing remainder stored in the division unit 30, and flip-flops 32 ($32_0$ through $32_{23}$).

An example of the generator polynomial is G (x) =$x^{24}+x^{23}+x^6+x^5+x+1$. The remainder table 10 stores remainders R0 through R50000 at addresses corresponding to the orders of x (i.e., power value) as they are obtained with respect to A(x)=$x^0$ through $x^{50000}$ which are input. The remainder table 10 can be accessed based on the order of the least significant bit of any given one of the sub-blccks SB1 through SBM-1 that constitute input data A(x). In the first embodiment, the remainder table 10 is configured to store all possible remainders so as to be able to cope with any sub-bit length by taking into account the fact that the input information bit string is divided into sub-blocks having arbitrary sizes.

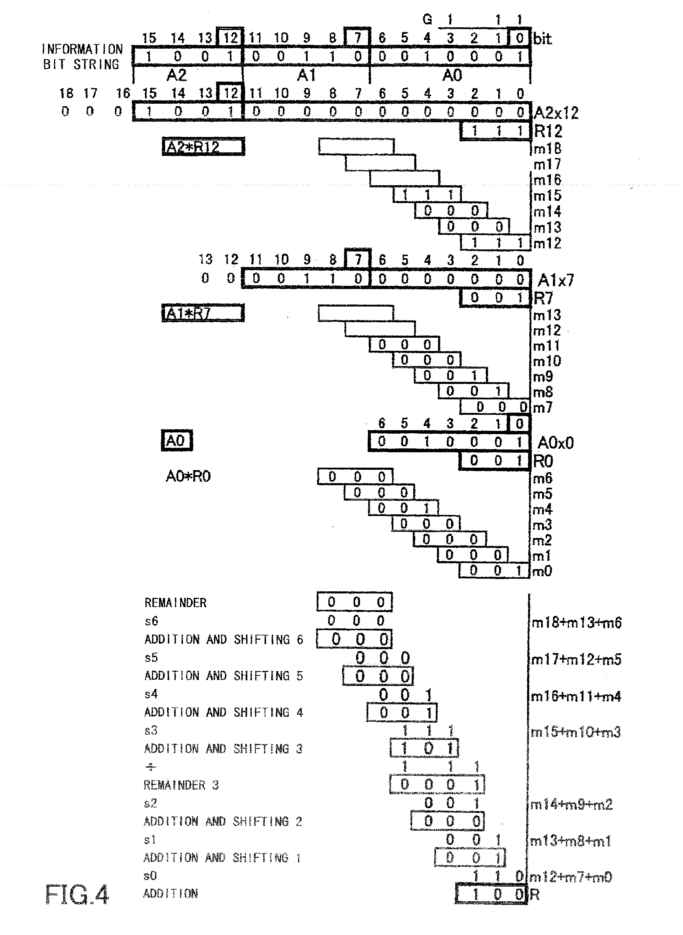

Fig. 4 is an illustrative drawing for explaining the operation of the division apparatus according to the first embodiment. Fig. 4 shows an example in which an input information bit string is divided into three sub-blocks, which are concurrently divided by generator polynomial G(x). Here, a specific example of division operation will be described with reference to a case in which generator polynomial G(x)=$x^3+x+1$ having an order of m=3 is used.

In Fig. 4, input information bit string A(x) is divided into a sub-block (SB) A2 comprised of bit15 through bit12, a sub-block A1 comprised of bit11 through bit7, and a sub-block A0 comprised of bit6 through bit0. The least significant bit of each one of the sub-blocks A2 through A0 has the order of $x^{12}$, $x^7$, and $x^0$, respectively.

Preferably, sub-bit strings having a length shorter than the longest bit length among the sub-blocks A2 through A0 have bits "0" (zeros) attached thereto on their higher-order side as many as necessary to reach the longest bit length, thereby making it easier for the addition unit 25 to align the phase of addition for remainder elements m (i.e., sub-results m of multiplication generated by the multipliers 21). In the illustrated example, the longest bet length is 7 bits of the sub-block A0. Accordingly, three "0" bits are attached to the bits of the sub-block A2 on the most-significant-bit side, and two "0" bits are attached to the bits of the sub-block A1 on the most-significant-bit side. The addition of "0" bits to a sub-bit string on its most-significant-bit side does not affect the division calculation.

At the initial stage of division operation, remainder values R12=111 and R7=001 are read from the remainder table 10 for storage in the registers $22_2$ and $22_1$, respectively, where these remainder values R12 and R7 are remainders left after dividing the least significant bits $x^{12}$ and $x^7$ of the sub-blocks A2 (x) and A1 (x) by G(x)=$x^3+x+1$. All the registers (i.e., flop-flops) 32 of the division unit 30 are in the initialized (reset) state.

Since the least significant bit $x^0$=1 of the sub-block A0 cannot be divided by third-order G (x), there is no need to refer to the remainder table 10 to obtain its remainder value R0=001. Attention is now focused on m6 through m0 that are obtained by multiplying the remainder value R0=001 by each bit of the bit string of the sub-block A0 successively from the most-significant bit to the least-significant bit. The bit string "0010001" that is obtained by arranging the least significant bits of m6 through m0 is equal to the input bit string "0010001". In the first embodiment, thus, a multiplier $21_0$ is not provided for the least-significant sub-block A0, and the addition unit 25 is configured to extract the bits of the least-significant sub-block A0 one by one from the most-significant bit to the least significant bit for addition to the results of other multiplication operations. In the explanation of Fig. 4, a description will be given as if the multiplier $21_0$ was in existence in order to show the consistency of division operation performed for each of the sub-blocks A2 through A0.

In this state, the bit strings A2(x) through A0(x) of the respective sub-blocks A2 through A0 are supplied one bit by one bit with the most-significant bit first. The multiplier $21_2$ multiplies the remainder value R12=111 by the most significant bit $x^{18}$=0 (i.e., one of the attached "0" bits) of A2(x), thereby producing three-bit remainder element m18=000. At the same time, the multiplier $21_1$ multiplies the remainder value R7=001 by the most significant bit $x^{13}$=0 of A1(x), thereby producing three-bit remainder element m13=000, and the multiplier $21_0$ multiplies the remainder value R0=001 by the most significant bit $x^6$=0 of A0(x), thereby producing three-bit remainder element m6=000. There is no multiplier $21_0$ for A0(x) in reality, so that the addition unit 25 extracts the most significant bit x6=0 of A0(x) at this timing, and retains the extracted bit as the least significant bit of the remainder element m6.

The addition unit 25 performs modulo-2 addition with respect to the remainder elements m18, m13, and m6, thereby supplying the first addition result s6=000 to the division unit 30. The division unit 30 adds (i.e., modulo-2 addition) the addition result s6=000 to the existing remainder value (all bits are "0" in the initial state), and shifts the obtained sum (i.e., 000) left by one bit. Since the most significant bit (i.e. flip-flop $32_3$) is zero, the shifted sum is retained as the first remainder value "000".

After this, the second addition result s5=000 is processed in the same manner, so that the second remainder value stored in the division unit 30 is "000". The third addition result is s4=001. Since the most significant bit is zero after the addition and shifting, the third remainder value is "010". Thereafter, the addition unit 25 performs modulo-2 addition with respect to the remainder elements m15, m10, and m3, thereby supplying the fourth addition result s3=111 to the division unit 30. The division unit 30 adds (i.e., modulo-2 addition) the fourth addition result s3=111 to the third remainder value "010", and shifts the obtained sum (i.e., "101") to the left by one bit. Since the most significant bit is "1", the shifted sum is divided (subtracted) by the generator polynomial G(x)=1011, thereby generating the fourth remainder value "001". The same processes are thereafter performed in the same manner. When the seventh addition result s0=110 is added to the sixth remainder value "010", the division unit 30 retains the final remainder value R=100.

[Second Embodiment]

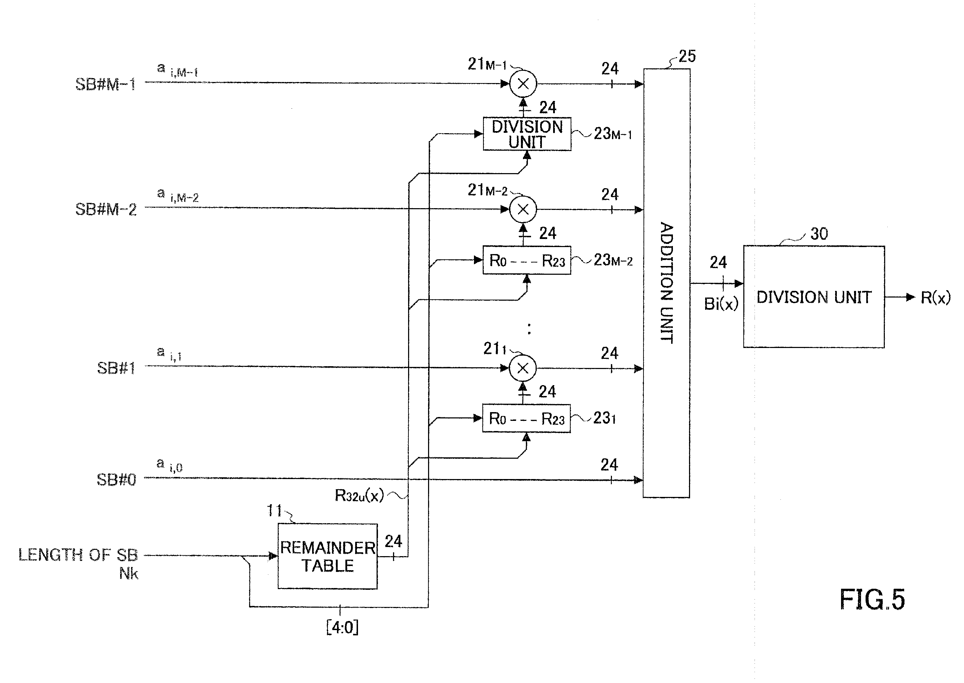

Fig. 5 is a block diagram showing a division apparatus according to a second embodiment. Fig. 5 shows a case in which the size of the remainder table is reduced. In this example, a remainder table 11 only stores every P-th remainder value that is selected at an interval. If a sub-block length for which a corresponding remainder value is not stored in the remainder table 11 is set, the corresponding remainder value is obtained through interpolation. In Fig. 5, division units $23_1$ through $23_{M-1}$ are provided, each of which has the same configuration as that shown in Fig. 3.

In the following, the principle of interpolation will be described. P represents a constant value that is arbitrarily chosen. $N_k$ is then divided as : $N_k = P \cdot u+1$ ($0 \leqq 1 \leqq P-1$). The quotient polynomial obtained by dividing $X^{Nk}$ by G(x) is represented as $Q_{Nk}(X)$, and the remainder polynomial is represented as $R_{Nk}(X)$. $X^{Nk}$ is then represented as:

$$x^{N_i} = x^{Pu+l}$$
$$= x^{Pu} x^l$$
$$= (Q_{Pu}(x)G(x) + R_{Pu}(x))x^l$$
$$= Q_{Pu}(x)G(x)x^l + R_{Pu}(x)x^l \qquad (11)$$

The first term of expression (11) is divisible by G(x), so that the remainder of $x^{Nk}$/G(x) is equal to the remainder obtained by dividing the second term $R_{Pu}(x)x^l$ by G(x). The computation of $R_{Pu}(x)x^l$/G(x) can be performed by a divider that utilizes shift registers. The value of $R_{Pu}(x)x^l$ is first set in the shift registers, which are then shifted by one cycle while entering the bit "0" one by one from the least significant bit of the shift registers.

In the second embodiment, the additional provision of a few exclusive OR gates for performing division operation in addition to the registers $22_1$ through $22_{M-1}$ of the first embodiment makes it possible to implement the divider units $23_1$ through $23_{M-1}$. Further, the division operation equal in length to the P-1 cycles at the maximum is all that is necessary at the time of making initial settings. The size of the remainder table 11, on the other hand, can be reduced to 1/P as large.

[Third Embodiment]

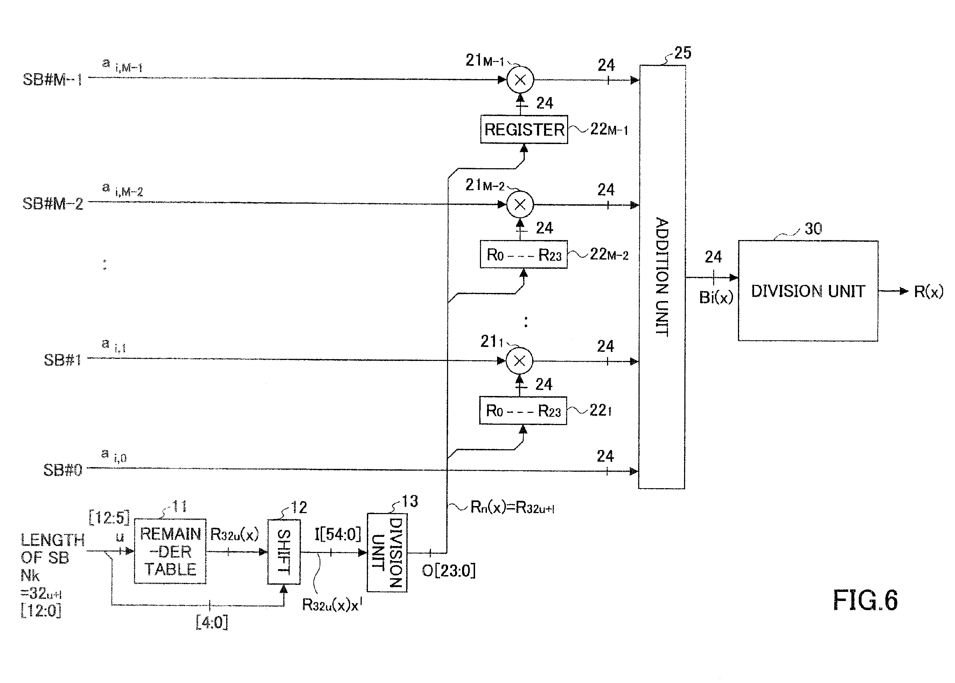

Fig. 6 is a block diagram showing a division apparatus according to a third embodiment. Fig. 6 shows a case in which the size of the remainder table is reduced, and, also, the time of making initial settings is shortened by performing the division (shifting) operation for a desired number of digits in a single cycle. In the third embodiment, the computation of $R_{Pu}$ (x) $x^1$/G (x) is performed through two stages, one for performing the computation of $R_{Pu}$ (x) $x^1$ and the other for dividing the obtained result by G(x). In Fig. 6, a shift register 12 and a division unit 13 comprised of exclusive-OR gates are provided.

The computation of $R_{Pu}(x)x^1$ is performed by repeatedly shifting $R_{Pu}(x)$ read from the remainder table 11 to the left by one bit while entering the bit "0" from the position of the least significant bit. When the remainder value $R_{Pu}$ (x) is shifted by m bits, the shifted $R_{Pu}(x)x^1$ includes m+P-1 bits at the maximum. The computation that divides the shifted result $R_{Pu}(x)x^1$ by G(x) is a division operation performed with respect to a fixed number of input bits that is as many as m+P-1. Such computation can thus be implemented by use of a unique fixed circuit comprised only of exclusive-OR gates. The initial settings can thus be performed at high speed in the third embodiment.

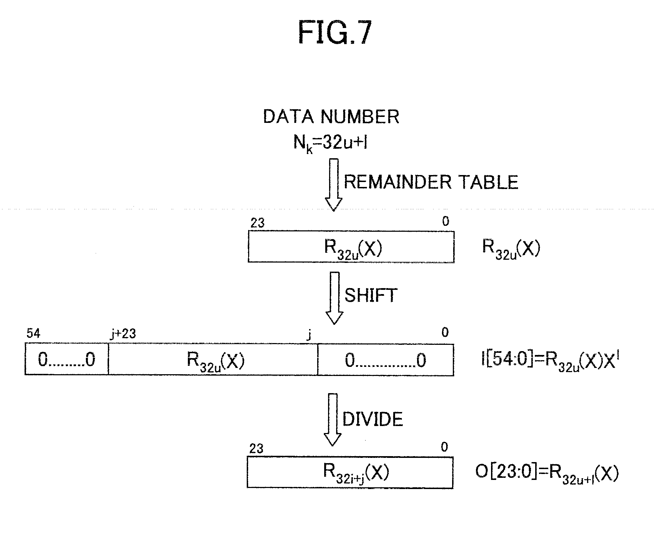

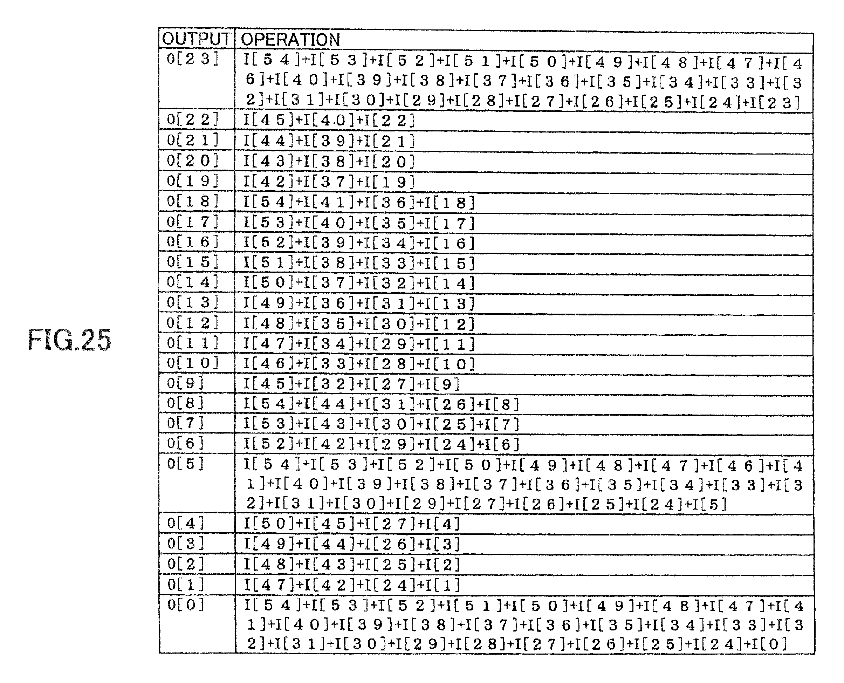

Fig. 7 is a drawing showing the concept of a process performed when the generator polynomial G(x) =$x^{24}$+$x^{21}$+$x^6$+$x^5$+x+1 is used with P=32. Fig. 25 is a table showing the logic operations performed by the division unit 13.

This table shows the relationships between 55-bit inputs I [54] through I[0] and 24-bit division results O[23] through O[0] that are obtained from the inputs by the division unit. Here, the operator "+" represents an exclusive-OR operation (which corresponds to modulo-2 addition). The output bit O[22] is formed as I[45]+I[40]-I[22], and the output bit O[21] is formed as I[44]+I[39]+I[21], for example. The remaining output bits are obtained in the same manner.

[Fourth Embodiment]

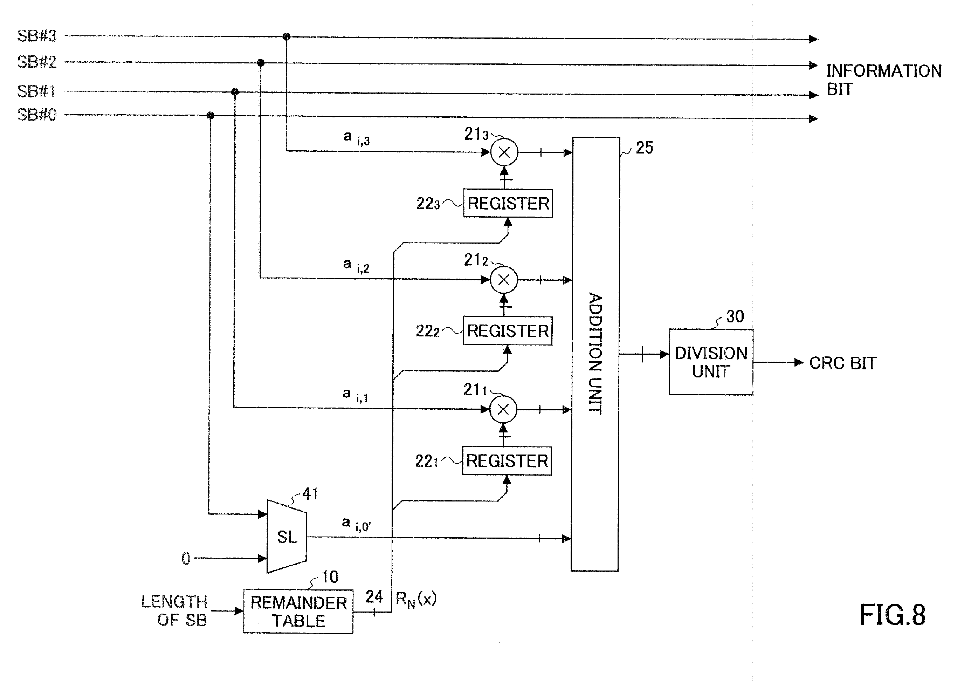

Fig. 8 is a block diagram showing an error-detection-coding apparatus according to a fourth embodiment. Bits "0" for m CRC bits are attached to information bits on its least-significant-bit side, and the entirety of these bits is divided into a plurality of sub-blocks that are input into a division apparatus. The final remainder value R obtained by the division unit 30 is used as the CRC bits. The error-detection-coding apparatus obtains a remainder polynomial R(x) by dividing by G(x) the product of $X^m$ and polynomial A(x) having the information bits as its coefficients, and then produces A(x) $x^m$+R(x) as a coded result. That is, the information bits plus the CRC bits constitute a code word. In the fourth embodiment, a selector (SL) 41 is provided for SB#0. Further, m bits each being "0" are attached to a divided portion of the information bits corresponding to SB#0, and the whole bits are input into the division unit as SB#0. Other aspects of the configuration are the same as those shown in Fig. 3.

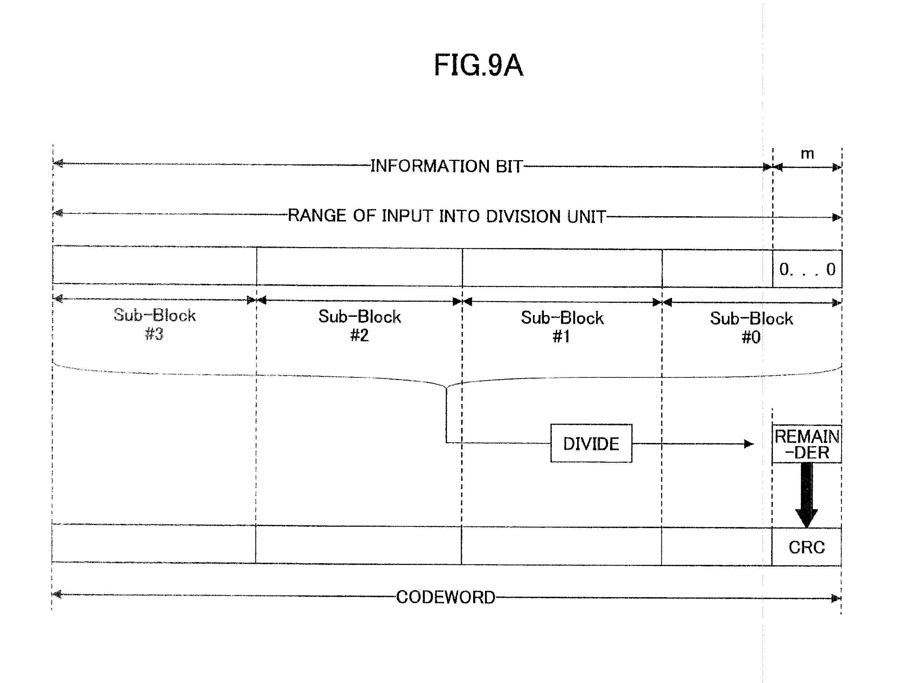

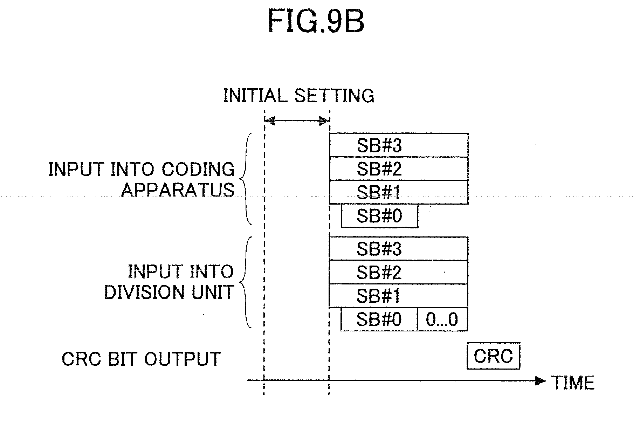

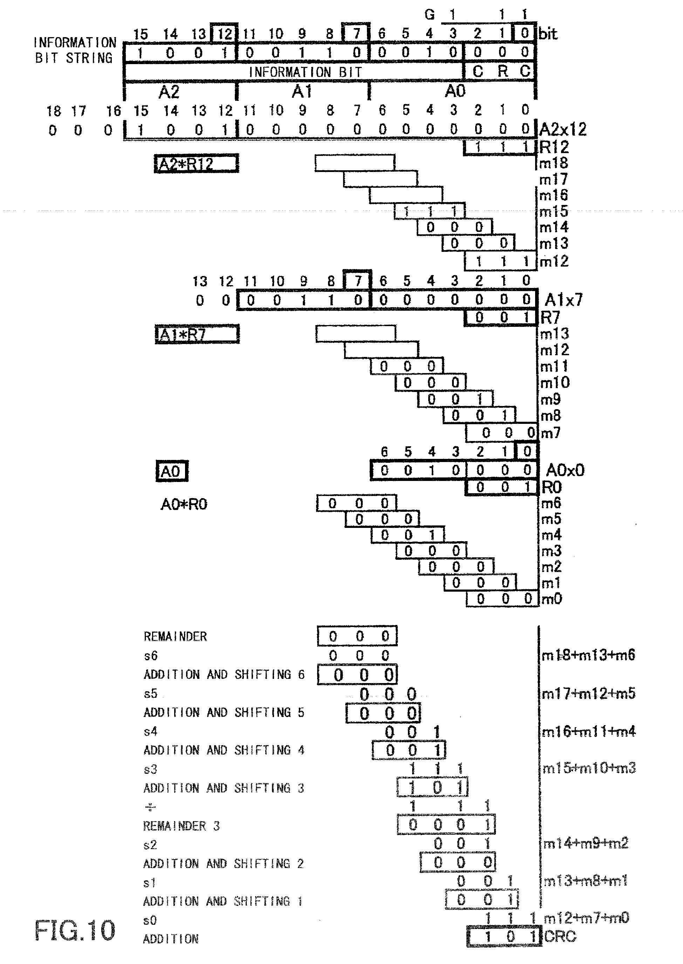

Figs. 9A and 9B and Fig. 10 are illustrative drawings for explaining the operation of the error-detection-coding apparatus according to the fourth embodiment. Fig. 9A illustrates the operation of a CRC coding process. The m bits each being "0" are attached to the information bits on its least-significant-bit side, and the whole bit string is divided into four sub-blocks SB#3 through SB#0 for prevision to the division unit. Fig. 9B shows a timing chart of such operation.

Fig. 10 shows a case in which the whole bit string comprised of 13 information bits and m attached bits each being "0" is divided into three sub-blocks A2 through A0 for provision to the division apparatus for generation of a CRC code. Here, a specific example of a CRC coding operation will be described with reference to a case in which generator polynomial G(x)=$x^3$+x+1 having an order of m=3 is used.

When the whole information bit string input into the division unit of the fourth embodiment is compared with the information bit string shown in Fig. 4, the positions of partitioning of the sub-blocks A2 through A0 are the same, and the only difference is that the least significant bit b0=1 in Fig. 4 is different from the least significant bit b0=0 (i.e., part of the m CRC bits) in Fig. 10. Consequently, the division operation up to Addition and Shifting 2 is the same as that shown in Fig. 4, and the final remainder value R (i.e., CRC bits) becomes equal to 101 in Fig. 10. Outputting the CRC bits b2 through b0 following the input information bits b15 and b3 generates a CRC code.

[Fifth Embodiment]

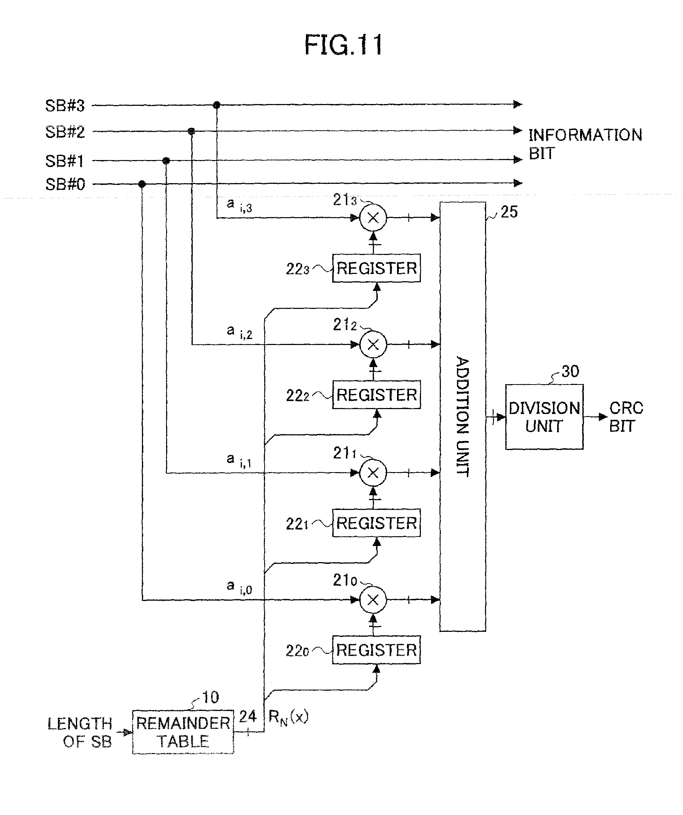

Fig. 11 is a block diagram showing an error-detection-coding apparatus according to a fifth embodiment. Only the input information bits are divided into a plurality of sub-blocks for provision to the division apparatus. A remainder value for each sub-block is obtained by dividing the least significant bit by G (x) while obtaining this least significant bit by shifting the sub-block to the left by m bits, and the obtained remainder value is multiplied by each bit of the sub-block with the most significant bit first. Then, the final remainder value R of the division unit 30 represents the CRC bits that are to be attached to the input information bits.

In the fifth embodiment, a multiplier $21_1$ and register $22_1$ are provided for SB#0. Provision is made such that a remainder value corresponding to an input that is shifted left by m bits is multiplied by each bit of SB#0 in addition to each bit of SB#3 through SB#1. Further, the addition unit 25 is configured to perform modulo-2 addition with respect to all the multiplication results obtained for SB#3 through SB#0. Other aspects of the configuration are the same as those shown in Fig. 3.

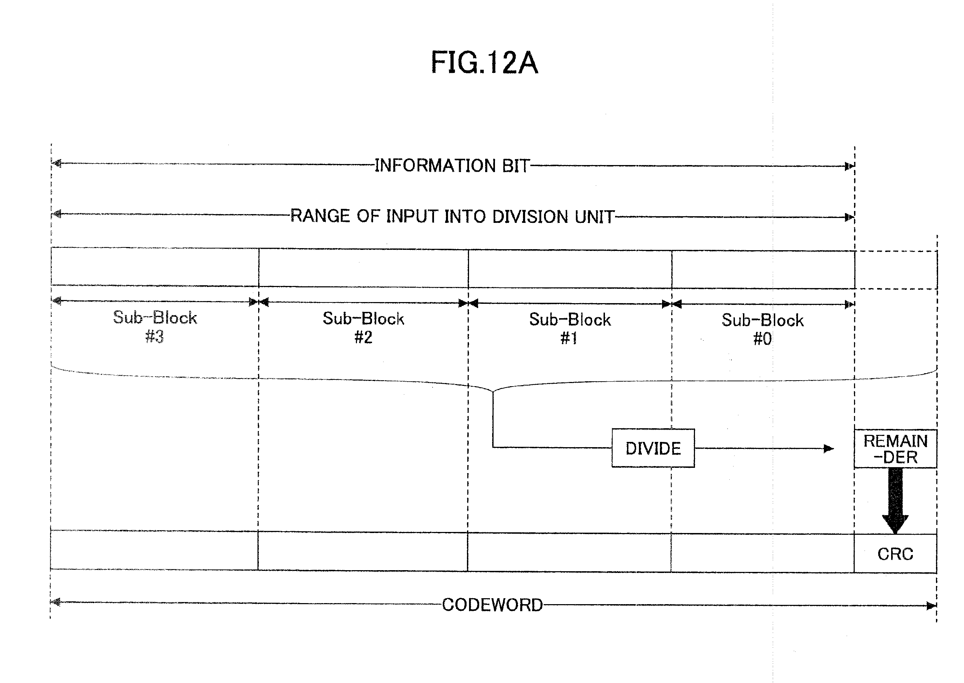

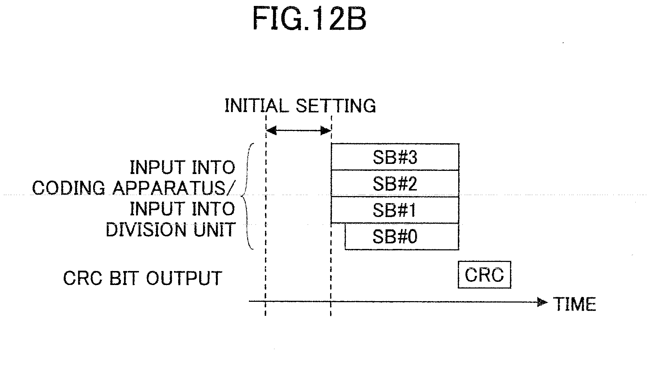

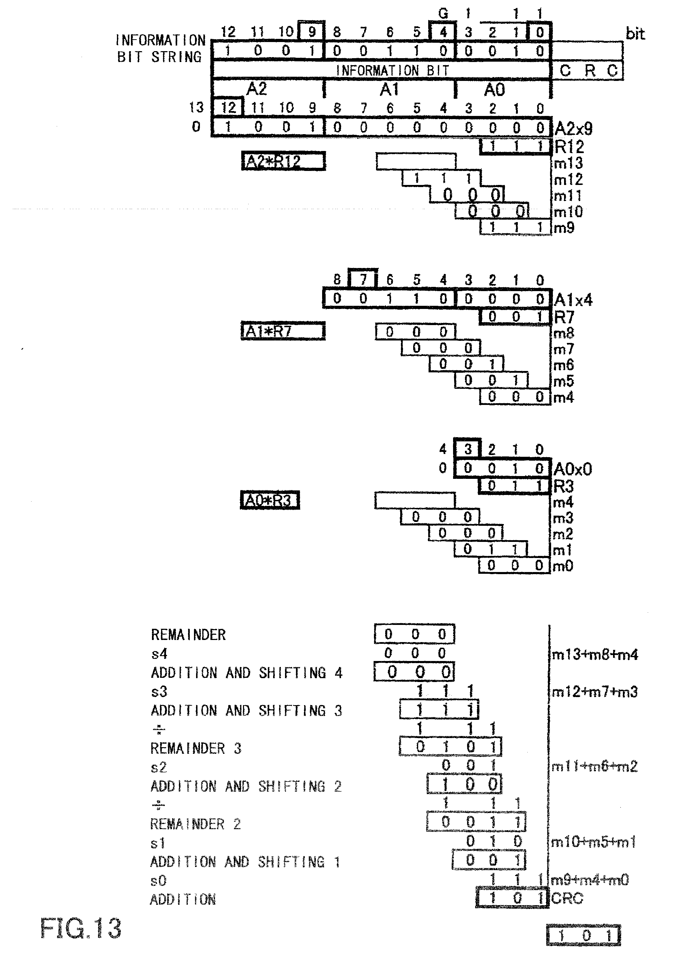

Figs. 12A and 12B and Fig. 13 are illustrative drawings for explaining the operation of the error-detection-coding apparatus according to the fifth embodiment. Fig. 12A illustrates the operation of a CRC coding process. Only the input information bits are divided into a plurality of sub-blocks SB#3 through SB#0 for provision to the division apparatus. Each one of the sub-blocks SB#3 through SB#0 are multiplied by a remainder value corresponding to an input that is shifted left by m bits for CRC, so that the final remainder value R of the division unit 30 represents the CRC bits that are to be attached to the input information bits. Fig. 12B shows a timing chart of such operation.

In Fig. 13, 13 information bits are divided into three sub-blocks A2 through A0 for provision to the division apparatus. Each sub-block is multiplied by a remainder value corresponding to an input that is shifted left by m bits, so that the final remainder value R of the division unit 30 represents the CRC bits that are to be attached to the input information bits. Here, a specific example of a CRC coding operation will be described with reference to a case in which generator polynomial $G(x)=x^3+x+1$ having an order of m=3 is used.

In the fifth embodiment, only input information bits are divided into three sub-blocks A2 through A0. A remainder value corresponding to an input that is shifted left by m bits (m=3) is retrieved from the remainder table 10 with respect to each of the sub-blocks A2 through A0 for storage in the registers $22_2$ through $22_0$. For example, the order of the least significant bit is 9 for the sub-block A2. The order of the least significant bit is 12 if the sub-block A2 is shifted left by 3 bits, so that a remainder value R12=111 corresponding to an order of 12 is retrieved from the remainder table 10. By the same token, a remainder value R7=C01 corresponding to an order of 7 is retrieved with respect to the sub-block A1, and a remainder value R3#011 corresponding to an order of 3 is retrieved with respect to the sub-block A0. The same multiplication and addition as previously described are performed for these pieces of information, resulting in the final remainder value R=101 (i.e., CRC bits) being retained in the division unit 30 at the end of the division operation. Outputting the CRC bits "101" following the input information bits b12 and b0 generates a CRC code.

[Sixth Embodiment]

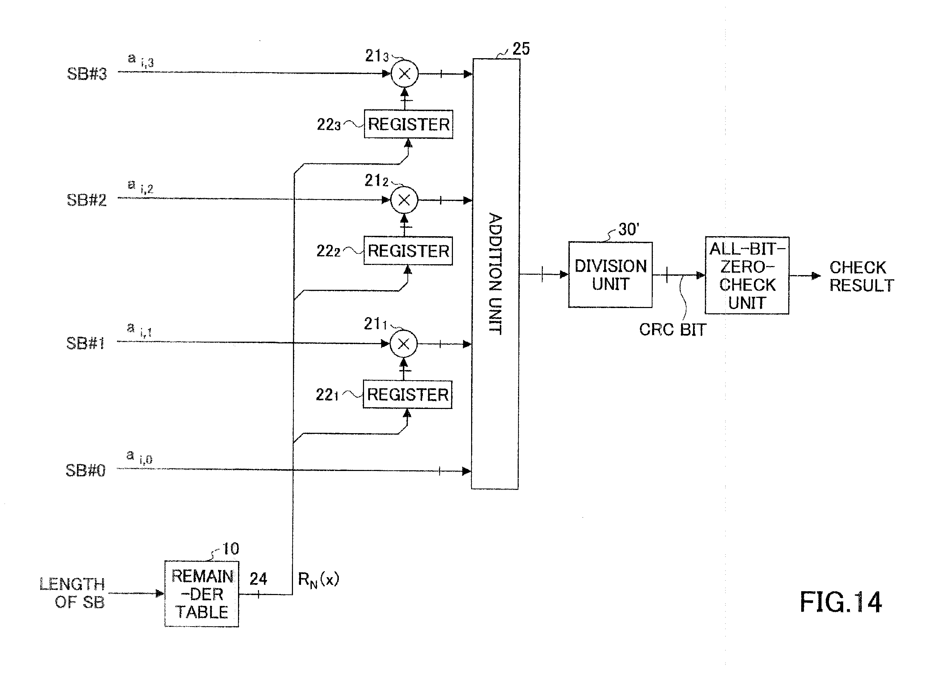

Fig. 14 is a block diagram showing an error-detection-decoding apparatus according to a sixth embodiment. All received bits inclusive of the CRC bits are input into a division apparatus for division by generator polynomial G(x). If all the bits of the remainder is zero, the CRC check indicates no error. Otherwise, the CRC check indicates the existence of error. In Fig. 14, the configuration of a division unit is substantially the same as that shown in Fig. 3. A division unit 30' is configured to output the final remainder value in parallel. An all-bit-zero-check unit 51 checks whether all the bits of the final remainder value output from the division unit 30' is zero. The all-bit-zero-check unit 51 produces an output indicative of no CRC error if all the bits are zero, and otherwise produces an output indicative of the existence of CRC error.

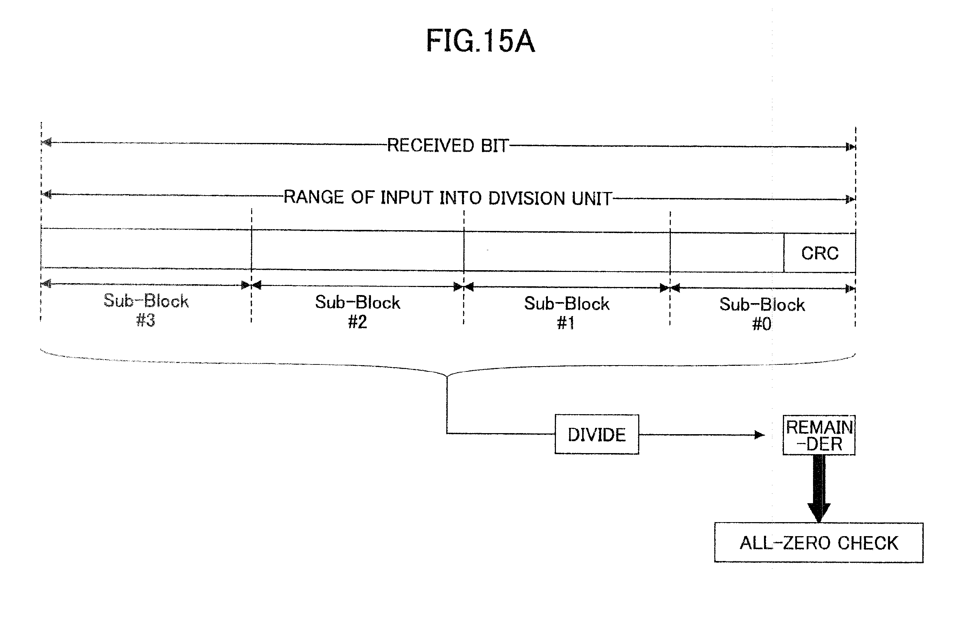

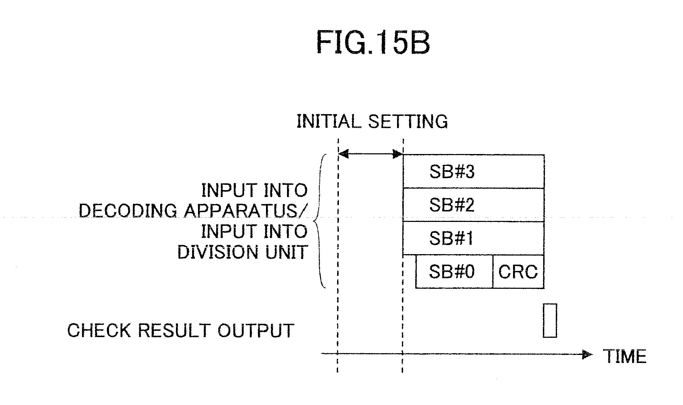

Figs. 15A and 15B are illustrative drawings for explaining the operation of the error-detection-decoding apparatus according to the sixth embodiment. Fig. 15A illustrates the operation of a CRC checking process, and Fig. 15B shows a timing chart of the CRC checking process. In Fig. 15A, the entirety of the received bits inclusive of the CRC bits is divided into four sub-blocks SB#3 through SB#0 for provision to the division apparatus. The division operation that divides the received bit string inclusive of the CRC bits is substantially the same as the division operation performed by the error-detection-coding apparatus described in connection with the fourth embodiment. When the division of the sub-blocks SB#3 through SB#0 inclusive of the CRC bits comes to an end, the division unit 30 has the remainder value retained therein as the result of the CRC check.

In the case of the coding apparatus shown in Fig. 10, the generated CRC is equal to 101. If the entirety of the received bits inclusive of the CRC bits "101" is received correctly, the final remainder value of the division unit 30' according to Figs. 15A and 15B will be "000", which indicates no CRC error. In other cases, a CRC error is detected.

[Seventh Embodiment]

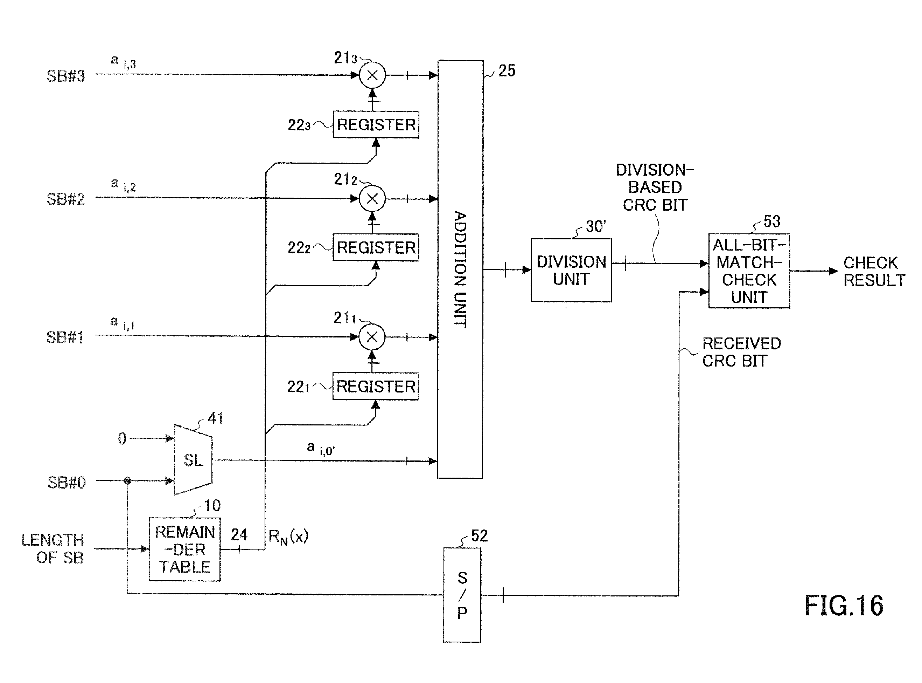

Fig. 16 is a block diagram showing an error-detection-decoding apparatus according to a seventh embodiment. The CRC bits of received bits are replaced by zeros for provision to the division apparatus. The result of the division is compared with the CRC bits extracted from the received bits. A match indicates no CRC error, and no match indicates a CRC error. In Fig. 16, a serial-to-parallel conversion unit (S/P) 52 converts a received CRC bit string into parallel signals, and an all-bit-match-check unit 53 compares generated CRC data output from the division unit 30' with the received CRC data output from the serial-to-parallel conversion unit 52. The all-bit-match-check unit 53 produces an output indicative of no CRC error if the comparison shows a match, and produces an output indicative of CRC error if the comparison shows no match.

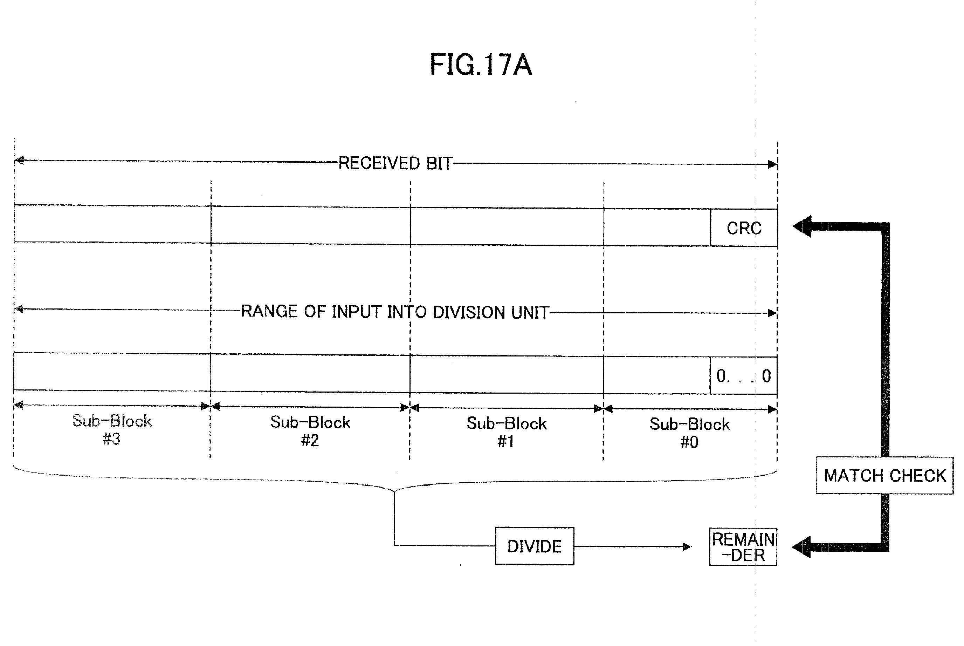

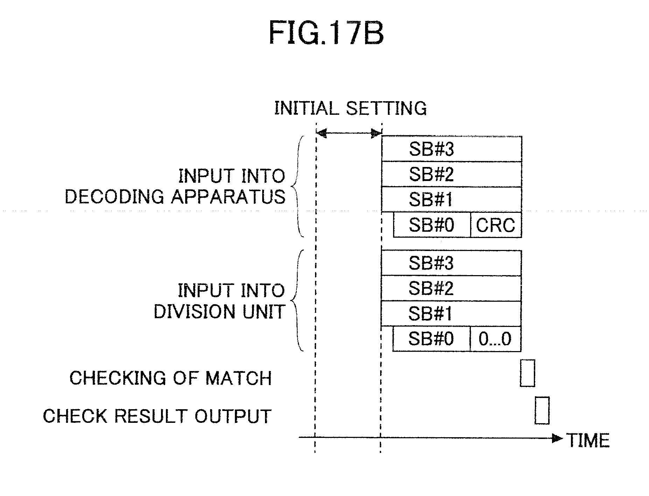

Figs. 17A and 17B are illustrative drawings for explaining the operation of the error-detection-decoding apparatus according to the seventh embodiment. Fig. 17A illustrates the operation of a CRC checking process, and Fig. 17B shows a timing chart of the CRC checking process. In Fig. 17A, the entirety of the received bits inclusive of the CRC bits is divided into four sub-blocks SB#3 through SB#0 for provision to the division apparatus. In so doing, the CRC bits are separated from the sub-block SB#0 of the received bit string, and are converted into parallel CRC bits by the serial-to-parallel conversion unit 52. In place of the separated CRC bits, as many zeros as the number of the CRC bits are added to SB#0 through the selector (SL) 41 for provision to the division apparatus.

The division operation that divides the received bit string inclusive of the CRC bits is substantially the same as the division operation performed by the error-detection-coding apparatus described in connection with the fourth embodiment. When the division of the sub-blocks SB#3 through SB#0 inclusive of the CRC bits being zero comes to an end, the division unit 30' has the remainder value retained therein as CRC bit-string information that is generated only from the received information. The all-bit-match-check unit 53 compares the generated CRC data output from the division unit 30' with the received CRC data output from the serial-to-parallel conversion unit 53. The all-bit-match-check unit 53 produces an output indicative of no CRC error if the comparison shows a match, and produces an output indicative of CRC error if the comparison shows no match.

[Eighth Embodiment]

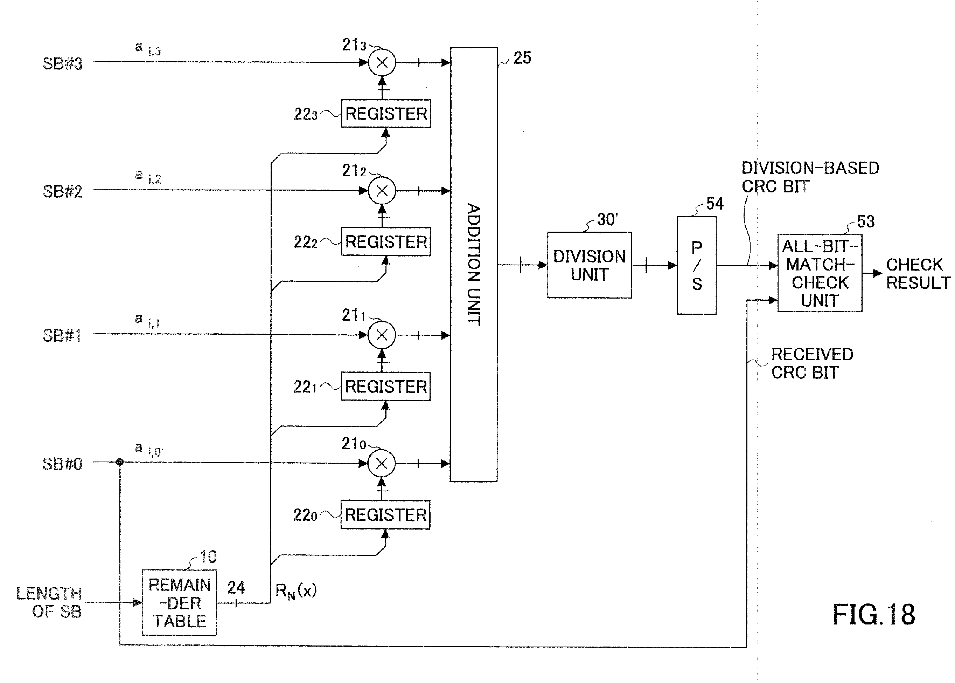

Fig. 18 is a block diagram showing an error-detection-decoding apparatus according to an eighth embodiment. Only the information bits of the received bit string are input into the division apparatus to generate CRC bits in the same manner as was described in connection with the fifth embodiment. The generated CRC bits are compared with the CRC bits separated from the received bit string. A match indicates no CRC error, and no match indicates a CRC error. In Fig. 18, a parallel-to-serial conversion unit (P/S) 54 converts parallel CRC bits output from the division unit 30' into a serial CRC bit string. In the same manner as was described in connection with Fig. 11, the multiplier $21_0$ and register $22_0$ are provided for SB#0 in the division apparatus.

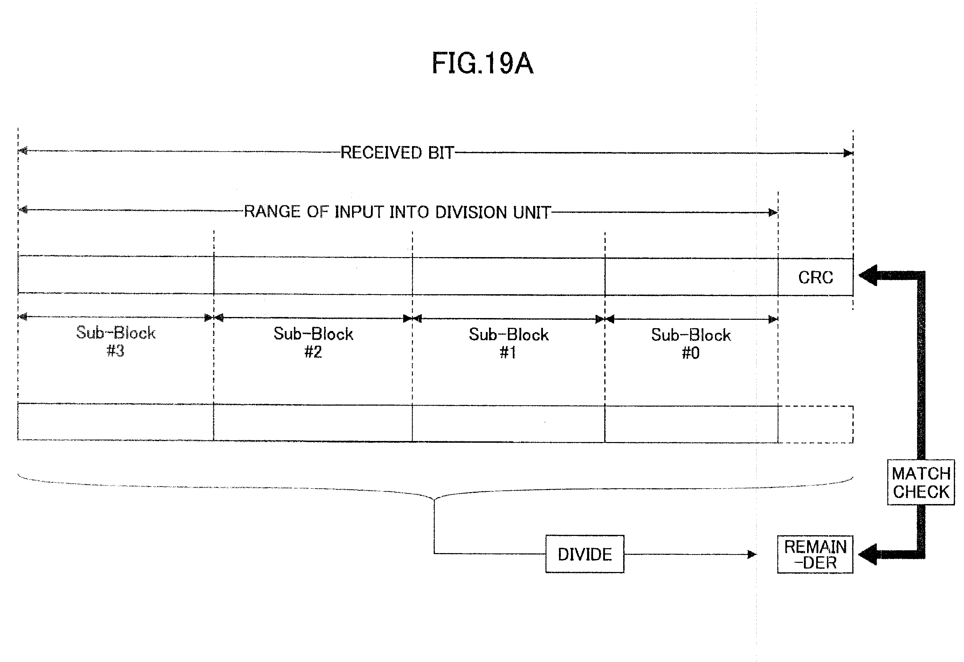

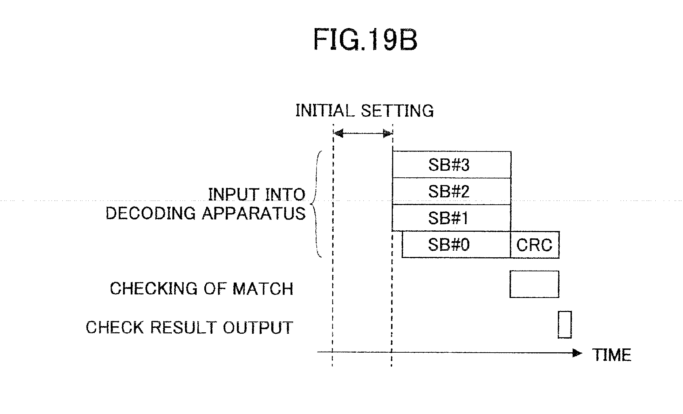

Figs. 19A and 19B are illustrative drawings for explaining the operation of the error-detection-decoding apparatus according to the eighth embodiment. Fig. 19A illustrates the operation of a CRC checking process, and Fig. 19B shows a timing chart of the CRC checking process. In Fig. 19A, only the information bits of the received bit string are divided into four sub-blocks SB#3 through SB#0 for provision to the division apparatus. The division operation that divides only the information bit string is substantially the same as the division operation performed by the error-detection-coding apparatus described in connection with the fifth embodiment. When the division of the sub-blocks SB#3 through SB#0 comprised only of the information bits comes to an end, the division unit 30' has the remainder value retained therein as CRC bit-string information that is generated only from the information bit string. The P/S conversion unit 54 converts the CRC bit-string information into a serial signal, which is then compared with the CRC bit string separated from the received bit string. A match indicates no CRC error, and no match indicates CRC error.

[Ninth Embodiment]

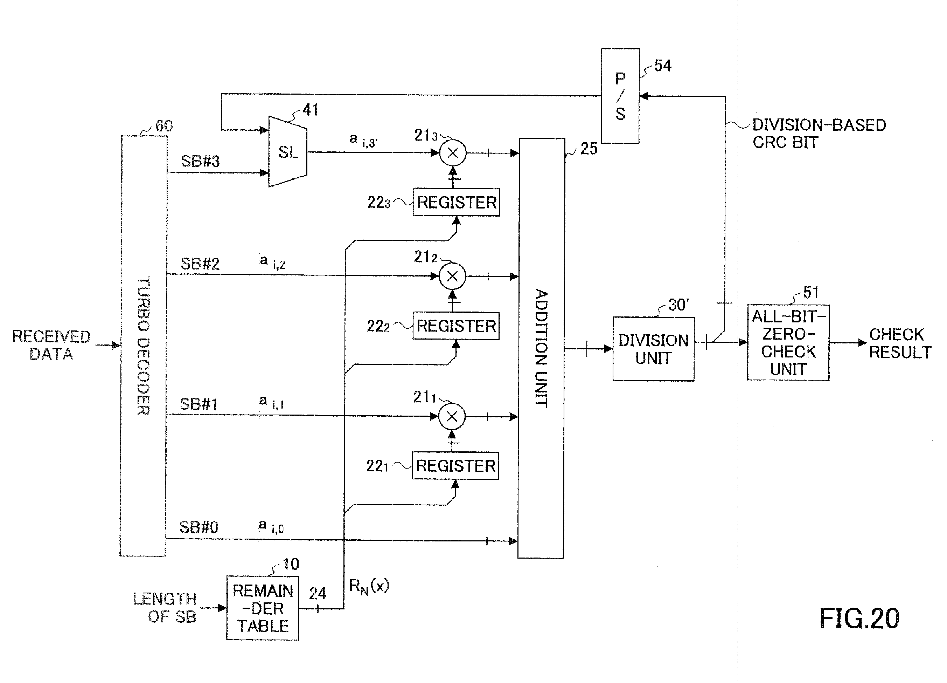

Fig. 20 is a block diagram showing an error-detection-decoding apparatus according to a ninth embodiment. Fig. 20 shows a case in which the error-detection-decoding apparatus of the present invention is coupled to a turbo decoder 60 that performs error-correction decoding in parallel. Patent Document 2 discloses a turbo decoder that is aimed at performing decoding at high speed when turbo codes are used as error correction codes. This decoder divides a code block into a plurality of sub-blocks, and performs error-correction decoding in parallel with respect to the plurality of sub-blocks. This significantly reduces the time required for error-correction decoding per code block. In the error-detection-decoding apparatus provided at a subsequent stage, the sub-blocks SB#3 through SB#0 that are error-correction-decoded by the turbo decoder 60 are input in parallel into the division apparatus, so that the CRC checks are performed in parallel, thereby significantly reducing the time required for the whole decoding process.

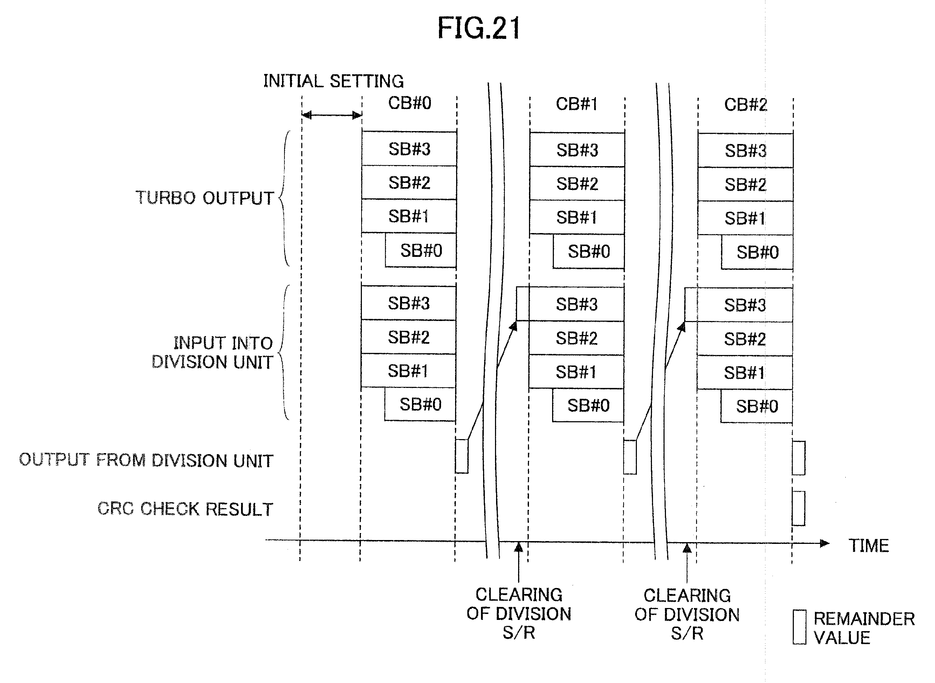

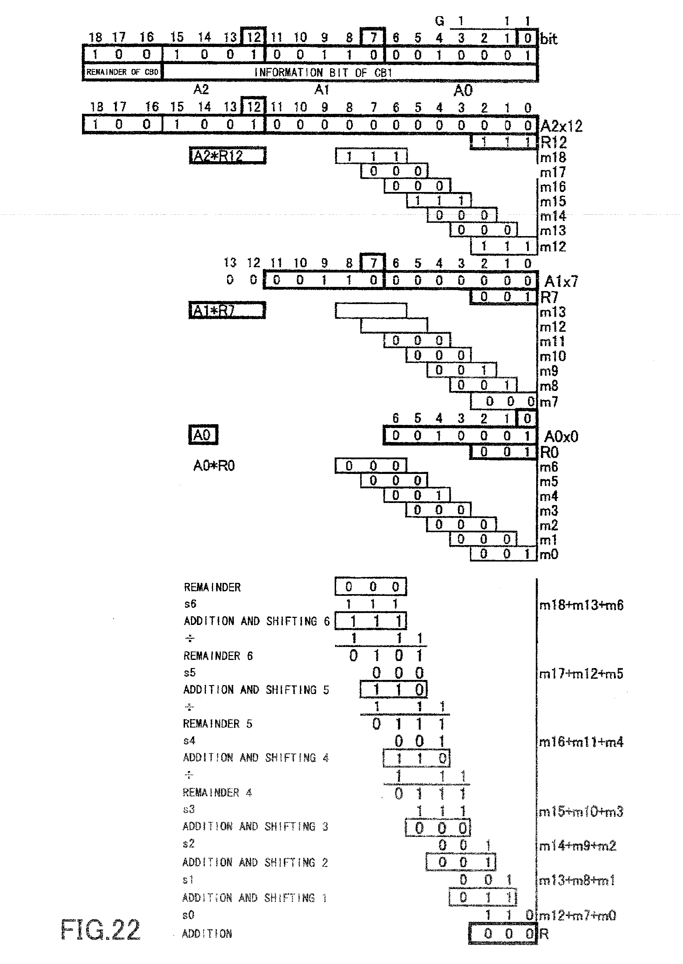

Fig. 21 and Fig. 22 are illustrative drawings for explaining the operation of the error-detection-decoding apparatus according to the ninth embodiment. Fig. 21 illustrates the operation of the error-detection-decoding apparatus. In these figures, the turbo decoder 60 performs error-correction decoding sequentially for each of the code blocks Cb#0, CB#1, and CB#3 of the received data. Each error-correction decoding is performed in parallel with respect to a plurality of sub-blocks SB#3 through SB#0 obtained by dividing the code block, thereby outputting error-correction-decoded sub-blocks SB#3 through SB#0 in parallel.

The error-detection-decoding apparatus receives the error-correction-decoded sub-blocks SB#3 through SB#0 in parallel, and also receives the final remainder value of SB#0 obtained by the error checking of CB#0 as it is attached to the head of SB#3 of CB#1. Such process is performed with respect to all code blocks. If the remainder value R obtained for the last code block is zero, the CRC check indicates no error. Otherwise, the CRC check indicates the existence of error.

If the sizes of the error-correction-decoded sub-blocks are the same across all the code blocks, initial setting for the division apparatus may be performed only once.

Fig. 22 is a drawing showing a case in which sub-blocks A2 through A0 for each code block CB#0 and CB#1 are input into the division apparatus in parallel from the turbo decoder 60, and are divided in parallel by generator polynomial $G(x)=x^3+x+1$. The division operation performed by the division apparatus is substantially the same as was described in connection with Fig. 4. Referring to Fig 4, the final remainder value R of the division unit 30' becomes "100" when the parallel processing of sub-blocks $A_2$ through A0 of the first code block CB#0 comes to an end.

Continuing the division operation by using G(x) with respect to the second code block CB#1 involves continuing the division operation by use of G(x) by attaching the remainder value R=100 obtained by the division of CB#0 to the most significant bit of CB#1 (i.e., the most significant bit b15 of the sub-block A2). This is illustrated in Fig. 22. Fortunately, three dummy bits (zeros) are padded in the head portion of the sub-block A2 (at bit positions b18 through b16). The remainder value R=100 obtained by the division of CB#0 is thus pasted over this portion. The division of CB#1 is then performed in the same manner as described above. At the end, the division unit 30' obtains the remainder value R=000 that is equivalent to a remainder value that would be obtained by continuously performing division using G(x) with respect to CB#0 and CB#1. In this example, the information bits happen to be the same between CB#0 and CB#1, so that the processing of CB#1 serves to perform a CRC check on the CRC code generated from the processing of CB#0. The division operations will thereafter be performed in the same manner. The CRC check will then be performed by using CRC bits that are attached at the end on the transmission side (e.g., CRC bits attached at the end of the sub-block A0 of the last code block).

In the above description, the division apparatus according to the ninth embodiment is directed to a configuration in which the error-detection-decoding apparatus performs error detection with respect to turbo-decoding results when turbo codes are used as error correction a codes. The application of the ninth embodiment, however, is not limited to this configuration. The division apparatus carries over a sub-remainder obtained by dividing a current code block by G (x) to the division operation of a next code block when sub-bit strings are provided for a plurality of sub-blocks into which each code block is divided, and may be utilized as the means to obtain the final remainder value when the last code block is provided. Such division apparatus may not only be used as an error-detection-decoding apparatus as described above, but also be used as an error-detection-coding apparatus.

In the embodiments described above, the division apparatus described in connection with the first embodiment was mainly used. Such configuration is not intended to be a limiting example. It is apparent that the division apparatus according to the second or third embodiment may as well be used.

In the embodiments described above, the adding of multiplication results by the addition unit 25 and the dividing of the sum by the division unit 30 are concurrently performed. Such configuration is not intended to be a limiting example. All the sums of multiplication results may be obtained first, followed by division by G(x).

In the embodiments described above, a specific example of division of an information bit string into certain sub-blocks was used. This is not intended to be a limiting example. The information bit string may be divided into sub-blocks having any desired number of bits.

Further, the present invention is not limited to these embodiments, but various variations and modifications may be made without departing from the scope of the present invention.

**Claims**

1.    A method of dividing an information bit string by a generator polynomial in a calculation apparatus having a multiplication unit and an addition unit, **characterized by** comprising:

dividing the information bit string into a plurality of sub-bit strings A1 through AN;
causing the multiplication unit to multiply a remainder value by each bit of a sub-bit string Ai ($1 \leqq i \leqq N$) successively with a most significant bit first so as to produce a multiplication result corresponding to the sub-bit string Ai, the remainder value being obtained by dividing a polynomial representation by the generator polynomial wherein the polynomial representation represents a bit string in which a bit position in the information bit string corresponding to a least significant bit of the sub-bit string Ai is set to "1" and remaining bit positions are set to "0"; and
dividing, by the generator polynomial, a polynomial representing a bit string obtained by the addition unit performing modulo-2 addition that adds up multiplication results corresponding to the sub-bit strings A1 through AN.

2.    An apparatus for dividing an information bit string by a generator polynomial, **characterized by** comprising:

a division unit configured to divide the information bit string into a plurality of sub-bit strings A1 through AN;
a multiplication unit configured to multiply a remainder value by each bit of a sub-bit string Ai ($1 \leqq N$) successively with a most significant bit first so as to produce a multiplication result corresponding to the sub-bit string Ai, the remainder value being obtained by dividing a polynomial representation by the generator polynomial wherein the polynomial representation represents a bit string in which a bit position in the information bit string corresponding to a least significant bit of the sub-bit string Ai is set to "1" and remaining bit positions are set to "0"; and
an addition unit configured to obtain a summed bit string by performing modulo-2 addition that adds up multiplication results corresponding to the sub-bit strings A1 through AN; and
a division unit configured to divide a polynomial representing the summed bit string by the generator polynomial.

**3.** An apparatus for dividing an information bit string, **characterized by** comprising:

a multiplication unit configured to multiply a remainder value by each bit of a sub-bit string successively with a most significant bit first so as to obtain a multiplication result, the sub-bit string being one of a plurality of sub-bit strings into which the information bit string is divided, and the remainder value being obtained by dividing a bit "1" corresponding to an order of a least significant bit of the sub-bit string by a generator polynomial;

an addition unit configured to perform modulo-2 addition that adds multiplication results obtained by the multiplication unit to an existing remainder value so as to obtain a sum; and

a division unit configured to successively divide the sum obtained by the addition unit by the generator polynomial to produce a remainder, which is retained as the existing remainder value.

**4.** The apparatus for dividing an information bit string as claimed in claim 3,
wherein the multiplication unit is configured to perform multiplication by adding to a given sub-bit string on a most-significant-bit side thereof as many zeros as necessary to make the given sub-bit string equal in length to a longest sub-bit string among all the sub-bit strings.

**5.** The apparatus for dividing an information bit string as claimed in claim 3,
wherein the multiplication unit is configured not to perform multiplication with respect to a lowest-order sub-bit string, and the addition unit is configured to extract each bit of the lowest-order sub-bit string successively with a most significant bit first for addition to multiplication results corresponding to the other sub-bit strings.

**6.** The apparatus for dividing an information bit string as claimed in claim 3, further comprising a remainder table configured to store remainder values provided in one-to-one correspondence to continuous orders, each of the remainder values being obtained with respect to a bit "1" of a corresponding order, wherein the multiplication unit is configured to retrieve from the remainder table a remainder value corresponding to the order of the least significant bit of the sub-bit string for multiplication with each bit of the sub-bit string.

**7.** The apparatus for dividing an information bit string as claimed in claim 3, further comprising:

a remainder table configured to store remainder values provided in one-to-one correspondence to orders selected at predetermined intervals, each of the remainder values being obtained with respect to a bit "1" of a corresponding order;

a retrieval unit configured to retrieve a remainder value corresponding to a largest order among the orders selected at the predetermined intervals that are smaller than the order of the least significant bit of the sub-bit string; and

another division unit configured to divide the retrieved remainder value plus zeros added on a least-significant-bit side thereof by the generator polynomial so as to obtain the remainder value corresponding to the order of the least significant bit of the sub-bit string,

wherein the multiplication unit is configured to multiply the remainder value obtained by said another division unit by each bit of the sub-bit string.

**8.** The apparatus for dividing an information bit string as claimed in claim 3, further comprising:

a remainder table configured to store remainder values provided in one-to-one correspondence to orders selected at predetermined intervals, each of the remainder values being obtained with respect to a bit "1" of a corresponding order;

a retrieval unit configured to retrieve a remainder value corresponding to a largest order among the orders selected at the predetermined intervals that are smaller than the order of the least significant bit of the sub-bit string; and

a shift unit configured to shift the retrieved remainder value left by a number of bits corresponding to the order of the least significant bit of the sub-bit string; and

another division unit configured to receive the shifted retrieved remainder value and to output a remainder value obtained by dividing the shifted retrieved remainder value by the generator polynomial, said another division unit being implemented as a combination of exclusive-OR gates,

wherein the multiplication unit is configured to multiply the remainder value obtained by said another division unit by each bit of the sub-bit string.

**9.** An error-detection-coding apparatus, **characterized by** comprising:

a division unit configured to add to an information bit string on a least-significant-bit side thereof as many zeros as necessary for CRC bits so as to produce an extended bit string and to divide the extended bit string into a plurality of sub-bit strings;

a multiplication unit configured to multiply a remainder value by each bit of one of the sub-bit strings successively with a most significant bit first so as to obtain a multiplication result, the remainder value being obtained by dividing a bit "1" corresponding to an order of a least significant bit of the one of the sub-bit strings by a generator polynomial;

an addition unit configured to perform modulo-2 addition that adds multiplication results obtained by the multiplication unit to an existing remainder value so as to obtain a sum; and

a division unit configured to successively divide the sum obtained by the addition unit by the generator polynomial to produce a remainder, which is retained as the existing remainder value.

**10.** An error-detection-coding apparatus, **characterized by** comprising:

a division unit configured to divide an information bit string into a plurality of sub-bit strings ;

a multiplication unit configured to multiply a remainder value by each bit of one of the sub-bit strings successively with a most significant bit first so as to obtain a multiplication result, the remainder value being obtained by dividing by a generator polynomial a bit "1" corresponding to an order of a least significant bit of the one of the sub-bit strings shifted left by as many bits as a number of CRC bits;

an addition unit configured to perform modulo-2 addition that adds multiplication results obtained by the multiplication unit to an existing remainder value so as to obtain a sum; and

a division unit configured to successively divide the sum obtained by the addition unit by the generator polynomial to produce a remainder, which is retained as the existing remainder value.

**11.** An error-detection-decoding apparatus, **characterized by** comprising:

a division unit configured to divide a received bit string inclusive of a CRC code into a plurality of sub-bit strings;

a multiplication unit configured to multiply a remainder value by each bit of one of the sub-bit strings successively with a most significant bit first so as to obtain a multiplication result, the remainder value being obtained by dividing a bit "1" corresponding to an order of a least significant bit of the one of the sub-bit strings by a generator polynomial;

an addition unit configured to perform modulo-2 addition that adds multiplication results obtained by the multiplication unit to an existing remainder value so as to obtain a sum;

a division unit configured to successively divide the sum obtained by the addition unit by the generator polynomial to produce a remainder, which is retained as the existing remainder value; and

an error-detection unit configured to check whether all bits of a final remainder value obtained by the division unit are zero.

**12.** An error-detection-decoding apparatus, **characterized by** comprising:

a division unit configured to divide a received bit string having CRC bits thereof replaced with zeros into a plurality of sub-bit strings;

a multiplication unit configured to multiply a remainder value by each bit of one of the sub-bit strings successively with a most significant bit first so as to obtain a multiplication result, the remainder value being obtained by dividing a bit "1" corresponding to an order of a least significant bit of the one of the sub-bit strings by a generator polynomial;

an addition unit configured to perform modulo-2 addition that adds multiplication results obtained by the multiplication unit to an existing remainder value so as to obtain a sum;

a division unit configured to successively divide the sum obtained by the addition unit by the generator polynomial to produce a remainder, which is retained as the existing remainder value; and

an error-detection unit configured to check whether a final remainder value obtained by the division unit matches the CRC bits extracted from the received bit string.

**13.** An error-detection-decoding apparatus, **characterized by** comprising:

a division unit configured to divide an information bit string included in a received bit string inclusive of a CRC code into a plurality of sub-bit strings;

a multiplication unit configured to multiply a remainder value by each bit of one of the sub-bit strings successively with a most significant bit first so as to obtain a multiplication result, the remainder value being obtained by dividing by a generator polynomial a bit "1" corresponding to an order of a least significant bit of the one of the sub-bit strings shifted left by as many bits as a number of CRC bits;

an addition unit configured to perform modulo-2 addition that adds multiplication results obtained by the multiplication unit to an existing remainder value so as to obtain a sum;

a division unit configured to successively divide the sum obtained by the addition unit by the generator polynomial to produce a remainder, which is retained as the existing remainder value; and

an error-detection unit configured to check whether a final remainder value obtained by the division unit matches the CRC code extracted from the received bit string.

14. An apparatus for dividing an formation bit string, **characterized by** comprising :

a multiplication unit configured to multiply a remainder value by each bit of a sub-bit string successively with a most significant bit first so as to obtain a multiplication result, the sub-bit string being one of a plurality of sub-bit strings into which an information bit string of each code block is divided, and the remainder value being obtained by dividing a bit "1" corresponding to an order of a least significant bit of the sub-bit string by a generator polynomial;

an addition unit configured to perform modulo-2 addition that adds multiplication results obtained by the multiplication unit to an existing remainder value so as to obtain a sum;

a division unit configured to successively divide the sum obtained by the addition unit by the generator polynomial to produce a remainder value, which is retained as the existing remainder value; and

an attaching unit configured to attach a remainder value obtained by the division unit for a current code block to a highest-order sub-bit string of a next code block.

# FIG.1

EP 1 947 796 A2

# FIG.2

$$B_i(x) = \sum_{l=0}^{m-1} b_{i,l} x^l$$

FIG.3

```
                                              G  1    1  1
          15  14  13 [12] 11  10  9  8 [7]  6  5  4  3  2  1 [0] bit
INFORMATION  1   0   0   1   0   0  1  1  0  0  0  1  0  0  0  1
BIT STRING
              A2              A1              A0

18  17  16  15  14  13 [12] 11  10  9  8  7  6  5  4  3  2  1  0
 0   0   0   1   0   0   1   0   0  0  0  0  0  0  0  0  0  0  0   A2x12
                                                        1  1  1   R12
    [A2*R12]                                                      m18
                                                                 m17
                                                                 m16
                                          1  1  1                m15
                                          0  0  0                m14
                                             0  0  0             m13
                                             1  1  1             m12

          13  12  11  10  9  8 [7]  6  5  4  3  2  1  0
           0   0   0   0  1  1  0   0  0  0  0  0  0  0           A1x7
                                             0  0  1             R7
    [A1*R7]                                                      m13
                                                                m12
                                  0  0  0                       m11
                                     0  0  0                    m10
                                     0  0  1                    m9
                                        0  0  1                 m8
                                        0  0  0                 m7

                              6  5  4  3  2  1 [0]
    [A0]                       0  0  1  0  0  0  1               A0x0
                                          0  0  1               R0
    A0*R0              0  0  0                                   m6
                         0  0  0                                m5
                            0  0  1                             m4
                               0  0  0                          m3
                                  0  0  0                       m2
                                     0  0  0                    m1
                                        0  0  1                 m0
```

| | | | |
|---|---|---|---|
| REMAINDER | 0 0 0 | | |
| s6 | 0 0 0 | | m18+m13+m6 |
| ADDITION AND SHIFTING 6 | 0 0 0 | | |
| s5 | 0 0 0 | | m17+m12+m5 |
| ADDITION AND SHIFTING 5 | 0 0 0 | | |
| s4 | 0 0 1 | | m16+m11+m4 |
| ADDITION AND SHIFTING 4 | 0 0 1 | | |
| s3 | 1 1 1 | | m15+m10+m3 |
| ADDITION AND SHIFTING 3 | 1 0 1 | | |
| ÷ | 1 1 1 | | |
| REMAINDER 3 | 0 0 0 1 | | |
| s2 | 0 0 1 | | m14+m9+m2 |
| ADDITION AND SHIFTING 2 | 0 0 0 | | |
| s1 | 0 0 1 | | m13+m8+m1 |
| ADDITION AND SHIFTING 1 | 0 0 1 | | |
| s0 | 1 1 0 | | m12+m7+m0 |
| ADDITION | 1 0 0 | | R |

**FIG.4**

FIG.5

EP 1 947 796 A2

FIG.6

# FIG.7

DATA NUMBER
$N_k = 32u + l$

⇓ REMAINDER TABLE

| 23 | 0 |
|---|---|
| $R_{32u}(X)$ | |

$R_{32u}(X)$

⇓ SHIFT

| 54 | j+23 | j | 0 |
|---|---|---|---|
| 0........0 | $R_{32u}(X)$ | 0..............0 | |

$I[54{:}0] = R_{32u}(X)X^l$

⇓ DIVIDE

| 23 | 0 |
|---|---|
| $R_{32i+j}(X)$ | |

$O[23{:}0] = R_{32u+l}(X)$

FIG.8

EP 1 947 796 A2

# FIG.9A

# FIG.9B

INITIAL SETTING

INPUT INTO CODING APPARATUS

| SB#3 |
| SB#2 |
| SB#1 |
| SB#0 |

INPUT INTO DIVISION UNIT

| SB#3 |
| SB#2 |
| SB#1 |
| SB#0 | 0...0 |

CRC BIT OUTPUT

CRC

→ TIME

G  1        1  1

| | 15 | 14 | 13 | 12 | 11 | 10 | 9 | 8 | 7 | 6 | 5 | 4 | 3 | 2 | 1 | 0 | bit |
|---|---|---|---|---|---|---|---|---|---|---|---|---|---|---|---|---|---|
| INFORMATION BIT STRING | 1 | 0 | 0 | 1 | 0 | 0 | 1 | 1 | 0 | 0 | 0 | 1 | 0 | 0 | 0 | 0 | |

| INFORMATION BIT | | | C | R | C |
|---|---|---|---|---|---|

A2        A1        A0

| 18 | 17 | 16 | 15 | 14 | 13 | 12 | 11 | 10 | 9 | 8 | 7 | 6 | 5 | 4 | 3 | 2 | 1 | 0 | |
|---|---|---|---|---|---|---|---|---|---|---|---|---|---|---|---|---|---|---|---|
| 0 | 0 | 0 | 1 | 0 | 0 | 1 | 0 | 0 | 0 | 0 | 0 | 0 | 0 | 0 | 0 | 0 | 0 | 0 | A2x12 |

| | | 1 | 1 | 1 | R12 |
|---|---|---|---|---|---|

A2*R12

| | | | m18 |
|---|---|---|---|
| | | | m17 |
| | | | m16 |
| 1 | 1 | 1 | m15 |
| 0 | 0 | 0 | m14 |
| 0 | 0 | 0 | m13 |
| 1 | 1 | 1 | m12 |

| 13 | 12 | 11 | 10 | 9 | 8 | 7 | 6 | 5 | 4 | 3 | 2 | 1 | 0 | |
|---|---|---|---|---|---|---|---|---|---|---|---|---|---|---|
| 0 | 0 | 0 | 0 | 1 | 1 | 0 | 0 | 0 | 0 | 0 | 0 | 0 | 0 | A1x7 |

| 0 | 0 | 1 | R7 |
|---|---|---|---|

A1*R7

| | | | m13 |
|---|---|---|---|
| | | | m12 |
| 0 | 0 | 0 | m11 |
| 0 | 0 | 0 | m10 |
| 0 | 0 | 1 | m9 |
| 0 | 0 | 1 | m8 |
| 0 | 0 | 0 | m7 |

| 6 | 5 | 4 | 3 | 2 | 1 | 0 | |
|---|---|---|---|---|---|---|---|
| 0 | 0 | 1 | 0 | 0 | 0 | 0 | A0x0 |

AO

| 0 | 0 | 1 | R0 |
|---|---|---|---|

A0*R0

| 0 | 0 | 0 | m6 |
|---|---|---|---|
| 0 | 0 | 0 | m5 |
| 0 | 0 | 1 | m4 |
| 0 | 0 | 0 | m3 |
| 0 | 0 | 0 | m2 |
| 0 | 0 | 0 | m1 |
| 0 | 0 | 0 | m0 |

| REMAINDER | 0 | 0 | 0 | | |
|---|---|---|---|---|---|
| s6 | 0 | 0 | 0 | | m18+m13+m6 |
| ADDITION AND SHIFTING 6 | 0 | 0 | 0 | | |
| s5 | | 0 | 0 | 0 | m17+m12+m5 |
| ADDITION AND SHIFTING 5 | | 0 | 0 | 0 | |
| s4 | | | 0 | 0 | 1 | m16+m11+m4 |
| ADDITION AND SHIFTING 4 | | | 0 | 0 | 1 | |
| s3 | | | | 1 | 1 | 1 | m15+m10+m3 |
| ADDITION AND SHIFTING 3 | | | | 1 | 0 | 1 | |
| ÷ | | | | | 1 | 1 | 1 | |
| REMAINDER 3 | | | | 0 | 0 | 0 | 1 | |
| s2 | | | | | 0 | 0 | 1 | m14+m9+m2 |
| ADDITION AND SHIFTING 2 | | | | 0 | 0 | 0 | |
| s1 | | | | | 0 | 0 | 1 | m13+m8+m1 |
| ADDITION AND SHIFTING 1 | | | | | 0 | 0 | 1 | |
| s0 | | | | | | 1 | 1 | 1 | m12+m7+m0 |
| ADDITION | | | | | | 1 | 0 | 1 | CRC |

FIG.10

# FIG.11

# FIG.12A

# FIG.12B

INITIAL SETTING

INPUT INTO
CODING APPARATUS/
INPUT INTO
DIVISION UNIT

| SB#3 |
|---|
| SB#2 |
| SB#1 |
| SB#0 |

CRC BIT OUTPUT

| CRC |
|---|

→ TIME

FIG.13

EP 1 947 796 A2

FIG.14

# FIG.15A

RECEIVED BIT

RANGE OF INPUT INTO DIVISION UNIT

| | | | CRC |

Sub-Block #3 | Sub-Block #2 | Sub-Block #1 | Sub-Block #0

DIVIDE → REMAIN-DER

ALL-ZERO CHECK

EP 1 947 796 A2

# FIG.15B

INITIAL SETTING

INPUT INTO
DECODING APPARATUS/
INPUT INTO
DIVISION UNIT

| SB#3 |  |
| SB#2 |  |
| SB#1 |  |
| SB#0 | CRC |

CHECK RESULT OUTPUT

TIME

FIG.16

EP 1 947 796 A2

# FIG.17A

EP 1 947 796 A2

# FIG.17B

INITIAL SETTING

INPUT INTO
DECODING APPARATUS

| SB#3 | |
|------|------|
| SB#2 | |
| SB#1 | |
| SB#0 | CRC |

INPUT INTO
DIVISION UNIT

| SB#3 | |
|------|------|
| SB#2 | |
| SB#1 | |
| SB#0 | 0...0 |

CHECKING OF MATCH

CHECK RESULT OUTPUT

TIME

FIG.18

# FIG.19A

RECEIVED BIT

RANGE OF INPUT INTO DIVISION UNIT

| | | | | CRC |

Sub-Block #3 | Sub-Block #2 | Sub-Block #1 | Sub-Block #0

DIVIDE → REMAIN -DER

MATCH CHECK

EP 1 947 796 A2

# FIG.19B

INITIAL SETTING

INPUT INTO
DECODING APPARATUS

| SB#3 | |
| SB#2 | |
| SB#1 | |
| SB#0 | CRC |

CHECKING OF MATCH

CHECK RESULT OUTPUT

TIME

FIG.20

EP 1 947 796 A2

# FIG.21

INITIAL SETTING

CB#0　　　CB#1　　　CB#2

TURBO OUTPUT
- SB#3
- SB#2
- SB#1
- SB#0

INPUT INTO DIVISION UNIT
- SB#3
- SB#2
- SB#1
- SB#0

OUTPUT FROM DIVISION UNIT

CRC CHECK RESULT

TIME

CLEARING OF DIVISION S/R

CLEARING OF DIVISION S/R

☐ REMAINDER VALUE

G 1    1 1

| 18 | 17 | 16 | 15 | 14 | 13 | 12 | 11 | 10 | 9 | 8 | 7 | 6 | 5 | 4 | 3 | 2 | 1 | 0 | bit |
|----|----|----|----|----|----|----|----|----|---|---|---|---|---|---|---|---|---|---|-----|
| 1 | 0 | 0 | 1 | 0 | 0 | 1 | 0 | 0 | 1 | 1 | 0 | 0 | 0 | 1 | 0 | 0 | 0 | 1 | |

REMAINDER OF CB0    INFORMATION BIT OF CB1

A2         A1        A0

| 18 | 17 | 16 | 15 | 14 | 13 | 12 | 11 | 10 | 9 | 8 | 7 | 6 | 5 | 4 | 3 | 2 | 1 | 0 | |
|----|----|----|----|----|----|----|----|----|---|---|---|---|---|---|---|---|---|---|---|
| 1 | 0 | 0 | 1 | 0 | 0 | 1 | 0 | 0 | 0 | 0 | 0 | 0 | 0 | 0 | 0 | 0 | 0 | 0 | A2x12 |

R12 = 1 1 1

A2*R12

1 1 1   m18
0 0 0   m17
0 0 0   m16
1 1 1   m15
0 0 0   m14
0 0 0   m13
1 1 1   m12

| 13 | 12 | 11 | 10 | 9 | 8 | 7 | 6 | 5 | 4 | 3 | 2 | 1 | 0 | |
|----|----|----|----|---|---|---|---|---|---|---|---|---|---|---|
| 0 | 0 | 0 | 0 | 1 | 1 | 0 | 0 | 0 | 0 | 0 | 0 | 0 | 0 | A1x7 |

R7 = 0 0 1

A1*R7

m13
m12
0 0 0   m11
0 0 0   m10
0 0 1   m9
0 0 1   m8
0 0 0   m7

| 6 | 5 | 4 | 3 | 2 | 1 | 0 | |
|---|---|---|---|---|---|---|---|
| 0 | 0 | 1 | 0 | 0 | 0 | 1 | A0x0 |

A0

R0 = 0 0 1

A0*R0

0 0 0   m6
0 0 0   m5
0 0 1   m4
0 0 0   m3
0 0 0   m2
0 0 0   m1
0 0 1   m0

REMAINDER    0 0 0
s6    1 1 1    m18+m13+m6
ADDITION AND SHIFTING 6   1 1 1
÷    1   1 1
REMAINDER 6    0 1 0 1
s5    0 0 0    m17+m12+m5
ADDITION AND SHIFTING 5   1 1 0
÷    1   1 1
REMAINDER 5    0 1 1 1
s4    0 0 1    m16+m11+m4
ADDITION AND SHIFTING 4   1 1 0
÷    1   1 1
REMAINDER 4    0 1 1 1
s3    1 1 1    m15+m10+m3
ADDITION AND SHIFTING 3   0 0 0
s2    0 0 1    m14+m9+m2
ADDITION AND SHIFTING 2   0 0 1
s1    0 0 1    m13+m8+m1
ADDITION AND SHIFTING 1   0 1 1
s0    1 1 0    m12+m7+m0
ADDITION    0 0 0   R

FIG.22

# FIG.23

EP 1 947 796 A2

```
+------------------------------------------+  +--------------------------------------------------------+
| TRANSMITTER                              |  | RECEIVER                                                |
|                                          |  |                                                         |
| +------------+ +------------+ +---------+ |  | +-----------+ +-----------+ +-----------+               |
| |INFORMATION | |  ERROR-    | | ERROR-  | |  | |  ERROR-   | |  ERROR-   | |INFORMATION|               |
| |GENERATING  |→|DETECTION-  |→|CORRECTION| →  |CORRECTION-|→|DETECTION- |→|EXTRACTING |               |
| |UNIT        | |CODING UNIT | |CODING UNIT|  | |DECODING   | |DECODING   | |UNIT       |               |
| +------------+ +------------+ +---------+ |  | |UNIT       | |UNIT       | +-----------+               |
|       ↑                                  |  | +-----------+ +-----------+                             |
|                                          |  |        RETRANSMISSION                                   |
|                                          |  |           REQUEST                                       |
+------------------------------------------+  +--------------------------------------------------------+
```

# FIG.24

INPUT → ⊕ → D → ⊕ → D → ... → ⊕ → D → ⊕ → D → OUTPUT

$g_1$    $g_{m-2}$    $g_{m-1}$

| D | : DELAY ELEMENT        ⊕ : EXCLUSIVE-OR

EP 1 947 796 A2

FIG.25

EP 1 947 796 A2

| OUTPUT | OPERATION |
|---|---|
| O[23] | I[54]+I[53]+I[52]+I[51]+I[50]+I[49]+I[48]+I[47]+I[46]+I[40]+I[39]+I[38]+I[37]+I[36]+I[35]+I[34]+I[33]+I[32]+I[31]+I[30]+I[29]+I[28]+I[27]+I[26]+I[25]+I[24]+I[23] |
| O[22] | I[45]+I[40]+I[22] |
| O[21] | I[44]+I[39]+I[21] |
| O[20] | I[43]+I[38]+I[20] |
| O[19] | I[42]+I[37]+I[19] |
| O[18] | I[54]+I[41]+I[36]+I[18] |
| O[17] | I[53]+I[40]+I[35]+I[17] |
| O[16] | I[52]+I[39]+I[34]+I[16] |
| O[15] | I[51]+I[38]+I[33]+I[15] |
| O[14] | I[50]+I[37]+I[32]+I[14] |
| O[13] | I[49]+I[36]+I[31]+I[13] |
| O[12] | I[48]+I[35]+I[30]+I[12] |
| O[11] | I[47]+I[34]+I[29]+I[11] |
| O[10] | I[46]+I[33]+I[28]+I[10] |
| O[9] | I[45]+I[32]+I[27]+I[9] |
| O[8] | I[54]+I[44]+I[31]+I[26]+I[8] |
| O[7] | I[53]+I[43]+I[30]+I[25]+I[7] |
| O[6] | I[52]+I[42]+I[29]+I[24]+I[6] |
| O[5] | I[54]+I[53]+I[52]+I[50]+I[49]+I[48]+I[47]+I[46]+I[41]+I[40]+I[39]+I[38]+I[37]+I[36]+I[35]+I[34]+I[33]+I[32]+I[31]+I[30]+I[29]+I[27]+I[26]+I[25]+I[24]+I[5] |
| O[4] | I[50]+I[45]+I[27]+I[4] |
| O[3] | I[49]+I[44]+I[26]+I[3] |
| O[2] | I[48]+I[43]+I[25]+I[2] |
| O[1] | I[47]+I[42]+I[24]+I[1] |
| O[0] | I[54]+I[53]+I[52]+I[51]+I[50]+I[49]+I[48]+I[47]+I[41]+I[40]+I[39]+I[38]+I[37]+I[36]+I[35]+I[34]+I[33]+I[32]+I[31]+I[30]+I[29]+I[28]+I[27]+I[26]+I[25]+I[24]+I[0] |

**EP 1 947 796 A2**

**REFERENCES CITED IN THE DESCRIPTION**

**Patent documents cited in the description**

- WO 2003587014 A
- WO 2003090362 A
- JP 2004015285 A